(19) Europäisches Patentamt
European Patent Office
Office européen des brevets

(11) EP 2 762 312 B1

(12) **EUROPEAN PATENT SPECIFICATION**

(45) Date of publication and mention of the grant of the patent:
**17.08.2016 Bulletin 2016/33**

(21) Application number: **12836498.1**

(22) Date of filing: **10.07.2012**

(51) Int Cl.:
***B41C 1/10*** *(2006.01)* *G03F 7/38* *(2006.01)*
*G03F 7/30* *(2006.01)* *G03F 7/20* *(2006.01)*
*G03F 7/029* *(2006.01)*

(86) International application number:
**PCT/JP2012/067584**

(87) International publication number:
**WO 2013/046856 (04.04.2013 Gazette 2013/14)**

(54) **PLATE MAKING METHOD OF LITHOGRAPHIC PRINTING PLATE**

VERFAHREN ZUR HERSTELLUNG EINER LITHOGRAFIEDRUCKPLATTE

PROCÉDÉ POUR PRODUIRE UNE PLAQUE D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.09.2011 JP 2011213222**

(43) Date of publication of application:
**06.08.2014 Bulletin 2014/32**

(73) Proprietor: **FUJIFILM Corporation**
**Tokyo 106-0031 (JP)**

(72) Inventor: **MORI Takanori**
**Shizuoka (JP)**

(74) Representative: **Hoffmann Eitle**
**Patent- und Rechtsanwälte PartmbB**
**Arabellastraße 30**
**81925 München (DE)**

(56) References cited:
**JP-A- 2005 196 030**
**JP-A- 2010 069 858**
**JP-A- 2010 208 234**
**JP-A- 2010 221 692**
**JP-A- 2010 234 589**
**JP-A- 2011 501 236**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 762 312 B1

**Description**

TECHNICAL FIELD

The present invention relates to a plate making method which can impart high printing durability to a lithographic printing plate obtained while well maintaining an on-press development property of a negative-working lithographic printing plate precursor capable of undergoing on-press development.

BACKGROUND ART

Heretofore, production of a lithographic printing plate has been performed by a system comprising exposing a lithographic printing plate precursor through a lith film which is an intermediate material. However, with the rapid progress of digitalization in the field of printing in recent years, the production process of lithographic printing plate is changing to a CTP system in which digital data input and edited in a computer are output directly to a lithographic printing plate precursor. Moreover, in an effort further rationalize the process, a development-free lithographic printing plate precursor has been developed which can perform printing as it is without undergoing development processing after exposure.

As one method for eliminating the processing step, a method referred to as on-press development is known wherein an exposed lithographic printing plate precursor is mounted on a plate cylinder of a printing machine, and dampening water and ink are supplied while rotating the plate cylinder to remove a photosensitive resin layer (image-recording layer) of the lithographic printing plate precursor. Specifically, the method comprises exposing a lithographic printing plate precursor, mounting the exposed lithographic printing plate precursor as it is on a printing machine, and conducting removal of an unnecessary portion of the image-recording layer in the initial stage of conventional printing process. A lithographic printing plate precursor suitable for such on-press development is required to have an image-recording layer which is soluble in dampening water or an ink solvent and infrared sensitivity in order to fulfil a bright room handling property suitable for development on a printing machine placed in a bright room.

As the lithographic printing plate precursor capable of undergoing on-press development, for instance, a lithographic printing plate precursor having provided on a hydrophilic support, an image-forming layer containing a hydrophobic thermoplastic polymer particle dispersed in a hydrophilic binding agent is known (see, for example, Patent Document 1). However, according to the technique the on-press development property is good, but the printing durability of a lithographic printing plate obtained is low.

In order to improve the printing durability of a lithographic printing plate precursor obtained from such a lithographic printing plate precursor capable of undergoing on-press development, a lithographic printing plate precursor having provided on a hydrophilic support, an image-recording layer (heat-sensitive layer) containing microcapsule having a polymerizable compound encapsulated therein is described (see, for example, Patent Documents 2 and 3). Also, a lithographic printing plate precursor having provided on a support, an image-recording layer (photosensitive layer) containing an infrared absorbing agent, a radical polymerization initiator and a polymerizable compound is described (see, for example, Patent Document 3). These techniques are intended to increase the printing durability by enhancing the image strength utilizing a polymerization reaction, but they are insufficient in view of compatibility between the on-press development property of a lithographic printing plate precursor and the printing durability of a lithographic printing plate obtained.

In response to the problems described above, various improvements in the lithographic printing plate precursor have been proposed. For instance, there are a proposal of introducing a crosslinkable group into a binder polymer used in an image-recording layer of a lithographic printing plate precursor (see Patent Document 4), a proposal of providing an intermediate layer (undercoat layer) containing a water-soluble polymer resin having a hydrophilic substituent capable of adsorbing to a surface of a support between the support and an image-recording layer of a lithographic printing plate precursor (see Patent Document 5), and a proposal of providing an overcoat layer containing an inorganic stratiform compound, for example, mica on an image-recording layer of a lithographic printing plate precursor (see Patent Document 6).

The standpoint of compatibility between the on-press development property and the printing durability has been improved by these techniques and the like, but it is not still sufficient and further improvements are requested.

Improvements by a plate making method have also been proposed. For instance, a method of accelerating curing of an image area in which after image exposure of a lithographic printing plate precursor of on-press development type, the on-press development is conducted after heating is known (see Patent Document 7). However, the method has problems in that the on-press development property decreases and in that the stain resistance in printing deteriorates. Also, a method in which just before or just after image exposure of a lithographic printing plate precursor of on-press development type having a photosensitive layer containing microcapsule with an infrared ray, an overall surface of the lithographic printing plate precursor is exposed to an ultraviolet ray is proposed (see Patent Document 8). However, according to the method, when a polymerizable compound is present outside the microcapsule, polymerization occurs

in the photosensitive layer corresponding to the non-image area upon the exposure to an ultraviolet ray so that on-press development cannot be performed in some cases.

PRIOR ART DOCUMENT

PATENT DOCUMENT

Patent Document 1: Japanese Patent No. 2938397

Patent Document 2: JP-A-2001-277740

Patent Document 3: JP-A-2001-277742

Patent Document 4: JP-A-2002-287334

Patent Document 5: JP-A-2006-188038

Patent Document 6: JP-A-2005-119273

Patent Document 7: U.S. Patent Publication No. 2009/0025591

Patent Document 8: JP-A-2005-196030

DISCLOSURE OF THE INVENTION

PROBLEMS THAT THE INVENTION IS TO SOLVE

An object of the present invention is to provide a plate making method of a lithographic printing plate which is good in both on-press development property of a lithographic printing plate precursor and printing durability of a lithographic printing plate obtained from the lithographic printing plate precursor.

MEANS FOR SOLVING THE PROBLEMS

The inventor has investigated compatibility between the on-press development property and the printing durability from the standpoint of plate making method, and found means for solving the problems. Specifically, the invention is as follows.

(1) A plate making method of a lithographic printing plate comprising performing steps a) to d) shown below in this order:

a) supplying a negative-working lithographic printing plate precursor having on a support an image-recording layer containing an infrared absorbing agent, an initiator represented by formula (I) and a polymerizable compound, wherein the image-recording layer is capable of being removed with at least one of ink and dampening water,
b) image-exposing the negative-working lithographic printing plate precursor with an infrared laser,
c) exposing the negative-working lithographic printing plate precursor to light for 5 minutes or more under a white lamp which has one light emission peak at 400 to 500 nm and one light emission peak at 500 to 600 nm and does not emit light at 380 nm or less,
d) removing an unexposed area with at least one of ink and dampening water to produce a lithographic printing plate.

$$Ar_1\text{-}I^+\text{-}Ar_2\ Z^- \qquad \text{Formula (I)}$$

In formula (I), $Ar_1$ and $Ar_2$ each represents a benzene ring which may have a substituent and $Ar_1$ and $Ar_2$ represents structures different from each other, and $Z^-$ represents a counter anion.

(2) The plate making method of a lithographic printing plate as described in (1) above, wherein a sum of Hammett a values of the substituents on the benzene ring represented by $Ar_2$ in formula (I) is a negative value.

(3) The plate making method of a lithographic printing pilate as described in (2) above, wherein a sum of Hammett σ values of the substituents on the benzene ring represented by $Ar_1$ in formula (I) is 0 or a negative value.

(4) The plate making method of a lithographic printing plate as described in (3) above, wherein an absolute value of a difference between the sum of Hammett σ values of the substituents on the benzene ring represented by $Ar_1$ and the sum of Hammett σ values of the substituents on the benzene ring represented by $Ar_2$ in formula (I) is 0.3 or more.

(5) The plate making method of a lithographic printing plate as described in any one of (1) to (4) above, wherein the image-recording layer contains a borate salt.

(6) The plate making method of a lithographic printing plate as described in any one of (1) to (5) above, wherein a time for the exposure to light under a white lamp in step d) is 10 minutes or more.

(7) The plate making method of a lithographic printing plate as described in (6) above, wherein the time for the exposure to light under a white lamp is 30 minutes or more.

According to the invention, the problem of compatibility between the on-press development property and the printing durability can be solved by the plate masking method described above. The mechanism of the invention is unclear, but it is supposed as follows.

Due to the exposure to light for 5 minutes or more under a white lamp which has one light emission peak at 400 to 500 nm and one light emission peak at 500 to 600 nm and does not emit light at 380 nm or less after the image exposure with an infrared laser, since the white lamp does not emit light at 380 nm or less, decomposition reaction of the initiator represented by formula (I) and the like does not occur, thereby hardly causing the polymerization reaction in the non-image area due to the white lamp.

On the other hand, it is believed that in the image area, by the image exposure with an infrared ray, absorption in the visible light range due to the initiator system increases to contribute to a curing reaction, thereby achieving high printing durability.

ADVANTAGE OF THE INVENTION

According to the invention, a plate making method of a lithographic printing plate which is excellent in both on-press development property of a lithographic printing plate precursor and printing durability of a lithographic printing plate obtained from the lithographic printing plate precursor can be provided.

MODE FOR CARRYING OUT THE INVENTION

The plate making method according to the invention comprises performing steps a) to d) shown above in this order. Hereinafter, each of the steps is described in turn.

[a) Supplying a negative-working lithographic printing plate precursor having on a support an image-recording layer containing an infrared absorbing agent, an initiator represented by formula (I) and a polymerizable compound, wherein the image-recording layer is capable of being removed with at least one of ink and dampening water]

The lithographic printing plate precursor according to the invention is a negative-working lithographic printing plate precursor having on a support an image-recording layer containing an infrared absorbing agent, an initiator represented by formula (I) and a polymerizable compound, wherein the image-recording layer is capable of being removed with at least one of ink and dampening water. Also, the lithographic printing plate precursor according to the invention may have an intermediate layer between the support and the image-recording layer and an overcoat layer on the image-recording layer.

[Infrared absorbing agent]

In the image-recording layer of the lithographic printing plate precursor according to the invention, an infrared absorbing agent is used in order to increase sensitivity to an infrared laser. The infrared absorbing agent has a function of converting the infrared ray absorbed to heat. The infrared absorbing agent for use in the invention is a dye or pigment

having an absorption maximum in a wavelength range from 760 to 1,200 nm.

As the dye, commercially available dyes and known dyes described in literatures, for example, Senryo Binran compiled by The Society of Synthetic Organic Chemistry, Japan (1970) can be used. Specifically, the dye includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Examples of preferred dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

As the infrared absorbing dye which can be preferably used in the invention, cyanine dyes described in JP-A-2001-133969 are exemplified.

Further, as other particularly preferred example, indolenine cyanine dyes described in JP-A-2002-278057 are exemplified.

Of the dyes, cyanine dyes, squarylium dyes, pyrylium dyes, nickel thiolate complexes and indolenine cyanine dyes are particularly preferred. Further, cyanine dyes and indolenine cyanine dyes are preferred. As a particularly preferred example of the dye, a cyanine dye represented by formula (a) shown below is exemplified.

Formula (a)

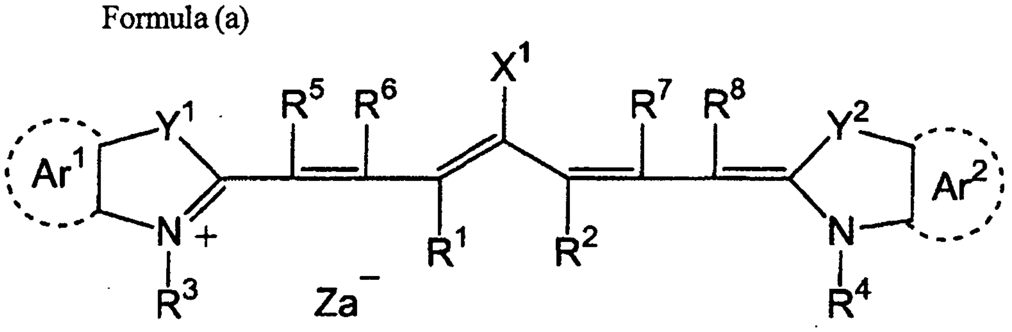

In formula (a), $X^1$ represents a hydrogen atom, a halogen atom, $-N(R^9(R^{10})$, $-X^2-L^1$ or a group shown below. $R^9$ and $R^{10}$, which may be the same or different, each represents an aromatic hydrocarbon group having from 6 to 10 carbon atoms which may have a substituent, an alkyl group having from 1 to 8 carbon atoms which may have a substituent or a hydrogen atom, or $R^9$ and $R^{10}$ may be combined with each other to form a ring. $R^9$ and $R^{10}$ each preferably represents a phenyl group. $X^2$ represents an oxygen atom or a sulfur atom. $L^1$ represents a hydrocarbon group having from 1 to 12 carbon atoms, an aromatic ring group containing a hetero atom (N, S, O, a halogen atom or Se) or a hydrocarbon group having from 1 to 12 carbon atoms and containing a hetero atom. $Xa^-$ in the following formula has the same meaning as $Za^-$ defined hereinafter. $R^a$ represents a hydrogen atom or a substituent selected from an alkyl group, an aryl group, a substituted or unsubstituted amino group and a halogen atom.

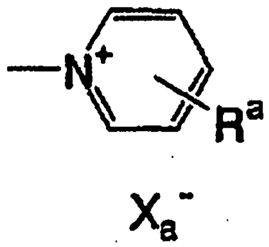

$R^1$ and $R^2$ each independently represents a hydrocarbon group having from 1 to 12 carbon atoms. In view of the preservation stability of a coating solution for recording layer, it is preferred that $R^1$ and $R^2$ each represents a hydrocarbon group having two or more carbon atoms. Further, it is particularly preferred that $R^1$ and $R^2$ are combined with each other to form a 5-membered ring or a 6-membered ring.

$Ar^1$ and $Ar^2$, which may be the same or different, each represents an aromatic hydrocarbon group which may have a substituent. Preferred examples of the aromatic hydrocarbon group include a benzene ring group and a naphthalene ring group. Preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms which may have a substituent Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. Preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of the preservation stability of a coating solution for recording layer.

In particular, in order to have absorption in a visible light range upon the image exposure with an infrared ray, a combination is preferred wherein $R^5$, $R^6$, $R^7$ and $R^8$ are hydrogen atoms respectively, $R^1$ and $R^2$ are combined with each other to form a 5-membered ring, and $X^1$ is $-NPh_2$. Further, a combination of the combination described above with a case where both $Y^1$ and $Y^2$ are dimethylmethylene groups is preferred.

Examples of the pigment for use in the invention include commercially available pigments and pigments described in Colour Index (C.I.), Saishin Ganryo Binran compiled by Pigment Technology Society of Japan (1977), Saishin Ganryo Ovo Gijutsu, CMC Publishing Co., Ltd. (1986) and Insatsu Ink Gijutsu, CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specifically, for example, insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black can be used. Of the pigments, carbon black is preferred.

The pigment may be used without undergoing surface treatment or may be used after the surface treatment Methods for the surface treatment include a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo, Saiwai Shobo, Insatsu Ink Gijutsu, CMC Publishing Co., Ltd. (1984) and Saishin Ganryo Oyo Gijutsu). CMC Publishing Co., Ltd. (1986).

The pigment has a particle size preferably in a range from 0.01 to 10 $\mu$m, more preferably in a range from 0.05 to 1 $\mu$m, particularly preferably in a range from 0.1 to 1 $\mu$m. In the range described above, good stability of the pigment dispersion in the coating solution for image-recording layer and good uniformity of the image-recording layer can be obtained.

As a method of dispersing the pigment, a known dispersion technique for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganrvo Oyo Gijutsu, CMC Publishing Co., Ltd. (1986).

In the case of adding the infrared absorbing agent to the image-recording layer of a negative-working lithographic

printing plate precursor, the addition amount thereof is so controlled that absorbance of the image-recording layer at the maximum absorption wavelength in the wavelength range from 760 to 1,200 nm measured by reflection measurement is preferably in a range from 0.3 to 1.2, and more preferably in a range from 0.4 to 1.1. In the range described above, the polymerization reaction proceeds uniformly in the thickness direction of the image-recording layer and good film strength of the image area and good adhesion property of the image area to the support are achieved.

The absorbance of the image-recording layer can be controlled depending on the amount of the infrared absorbing agent added to the image-recording layer and the thickness of the image-recording layer. The measurement of the absorbance can be carried out in a conventional manner. The method for measurement includes, for example, a method of forming an image-recording layer having a thickness determined appropriately in the range necessary for a coating amount after drying of the lithographic printing plate precursor on a reflective support, for example, an aluminum plate, and measuring reflection density of the image-recording layer by an optical densitometer or a spectrophotometer according to a reflection method using an integrating sphere.

[Initiator represented by formula (I)]

In the image-recording layer of the lithographic printing plate precursor according to the invention, an initiator (iodonium salt) represented by formula (I) shown below is used.

$$Ar_1\text{-}I^+\text{-}Ar_2\ Z^- \qquad \text{Formula (I)}$$

In formula (I), $Ar_1$ and $Ar_2$ each represents a benzene ring which may have a substituent and $Ar_1$ and $Ar_2$ represents structures different from each other, and $Z^-$ represents a counter anion. The term wherein $Ar_1$ and $Ar_2$ have the structures different from each other means that the structures of $Ar_1$ and $Ar_2$ including the substituents thereof are different from each other.

The counter anion represented by $Z^-$ is preferably a halide ion, a perchlorate ion, a tetrafluoroborate ion, a hexafluorophosphate ion, a carboxylate ion or a sulfonate ion, and more preferably, a hexafluorophosphate ion or a sulfonate ion.

In particular, in order to have absorption in a visible light range upon the image exposure with an infrared ray, an iodonium salt is preferred wherein $Ar_1$ and $Ar_2$ are different from each other and a sum of Hammett $\sigma$ values of the substituents on the benzene ring represented by $Ar_2$ is a negative value.

In particular, it is preferred in formula (I) that the sum of Hammett $\sigma$ values (hereinafter, also referred to as a "$Ar_2$ Hammett value") of the substituents on the benzene ring represented by $Ar_2$ is a negative value and a sum of Hammett $\sigma$ values (hereinafter, also referred to as a "$Ar_1$ Hammett value") of the substituents on the benzene ring represented by $Ar_1$ is 0 or less.

Furthermore, it is preferred that an absolute value of a difference between the sum of Hammett $\sigma$ values of the substituents on the benzene ring represented by $Ar_1$ and the sum of Hammett $\sigma$ values of the substituents on the benzene ring represented by $Ar_2$ is 0.3 or more.

A combination of such a preferred iodonium salt with a cyanine dye represented by formula (a) wherein $R^5$, $R^6$, $R^7$ and $R^8$ are hydrogen atoms respectively, $R^1$ and $R^2$ are combined with each other to form a 5-membered ring, and $X^1$ is $-NPh_2$ is preferred. Further, a combination thereof with the cyanine dye represented by formula (a) wherein, in addition, both $Y^1$ and $Y^2$ are dimethylmethylene groups is more preferred.

The Hammett $\sigma$ value is a value which shows the influence of a meta substituent and a para substituent on an acid dissociation equilibrium of benzoic acid in water at 25°C as described in Naoki Inamoto, Kagaku Seminar 10, Hammett Soku-Kozo to Hannosei-, Maruzen Co., Ltd., June, 1983. A negative value indicates that the substituent is an electron donating substituent and a positive value indicates that the substituent is an electron withdrawing substituent. As to an ortho substituent, the Hammett $\sigma$ value is calculated by using the value of the substituent at the p-position therefor.

In case of calculating the sum of Hammett $\sigma$ values, a $\sigma m$ value is used for the substituent at the m-position with respect to the C-I bond, and a op value is used for the substituent at the p-position.

The iodonium salt according to the invention is preferably an iodonium salt wherein when the sum of the Hammett $\sigma$ values in each benzene ring is calculated, the sum of at least one benzene ring is a negative value, and more preferably the iodonium salt wherein, in addition, the sum of the other benzene ring is 0 or a negative value.

As the iodonium salt according to the invention, any iodonium salt may be used as long as it is represented by formula (a) wherein two benzene rings are different from each other and the sum of Hammett $\sigma$ values of the substituents on the benzene ring represented by $Ar_2$ is a negative value. An iodonium salt represented by formula (II) shown below is more preferred, where the substituents on two benzene rings are different from each other and the sum of Hammett $\sigma$ values of the substituents on at least one benzene ring is a negative value.

Formula (II)

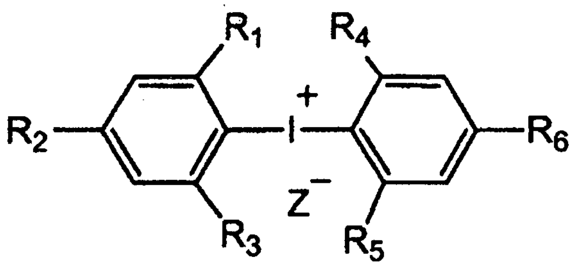

In formula (II), $R_1$ to $R_6$ each independently represents a hydrogen atom, an alkyl group, an aryl group, an alkenyl group, an alkynyl group, a halogen atom, a cyano group, a nitro group, $-OR_7$, $-OCOR_7$, $-OCOR_7R_8$, $-OSO_2R_7$, $-OPO(OR_7)(OR_8)$, $-OSiR_7R_8R_9$, $-COR_7$, $-COOR_7$, $-CONR_7R_8$, $-NR_7R_8$, $-NR_7COR_8$, $-NR_7COOR_8$, $-NR_7CONR_8R_9$, $-N(COR_7)(COR_8)$, $-N^+R_7R_8R_9 \cdot Y^-$, $-NR_7SO_2R_8$, $-SR_7$, $-SOR_7$, $-SO_2R_7$, $-SO_3R_7$, $-SO_2NR_7R_8$, $-PR_7R_8$, $-PO(OR_7)(OR_8)$ or $-SiR_7R_8R_9$, $R_7$ to $R_9$ each independently represents a hydrogen atom, an alkyl group, an aryl group, an alkenyl group or an alkynyl group, and $Z^-$ and $Y^-$ each represents a counter anion.

Of the substituents described above, examples of the substituent having a positive Hammett σ value and the substituent having a negative Hammett σ value are set forth below.

σm > 0: a halogen atom, a haloalkyl group, a cyano group, a nitro group, $-OCOR_7$, $-OSO_2R_7$, $-COR_7$, $-COOR_7$, $-CONR_7R_8$ and $-SO_2R_7$
σm < 0: $-NR_7R_8$ and an allyl group
σp > 0: a halogen atom, a haloalkyl group, a cyano group, a nitro group, $-OCOR_7$, $-OSO_2R_7$, $-COR_7$, $-COOR_7$, $-CONR_7R_8$ and $-SO_2R_7$
σp < 0: $-NR_7R_8$, $-OR_7$ and an alkyl group.

The case where $R^2$ and $R_5$ include an alkyl group or $-OR_7$ is preferred, and the case where $R_2$, $R_4$, $R_5$ and $R_6$ include an alkyl group or $-OR_7$ is particularly preferred. A number of carbon atoms included in the alkyl group or $R_7$ is preferably from 1 to 18, more preferably from 1 to 12, and still more preferably from 1 to 8.

Specific examples of the iodonium salt for use in the invention are set forth below, but the invention should not be construed as being limited thereto.

t

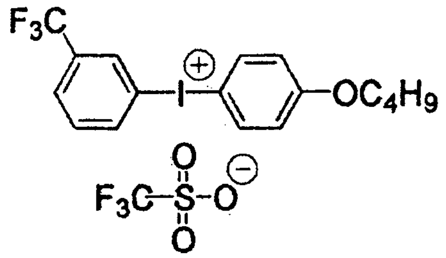

(Io-1)

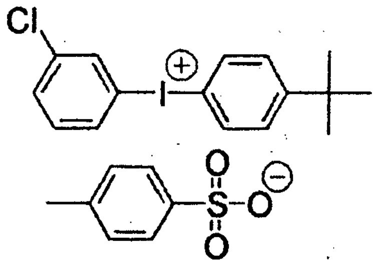

(Io-2)

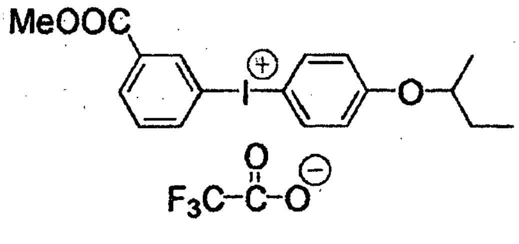

(Io-3)

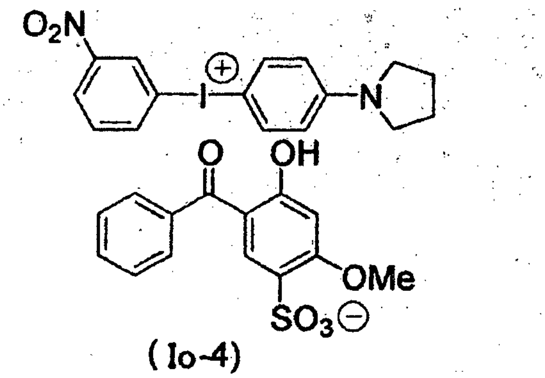

(Io-4)

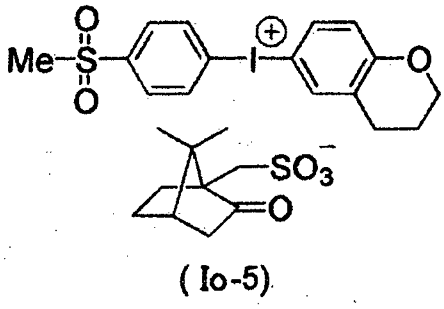

(Io-5)

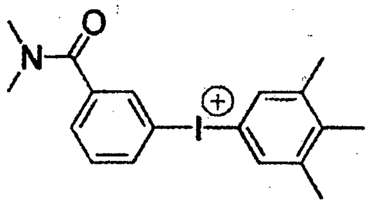

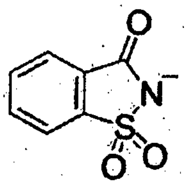

(Io-6)

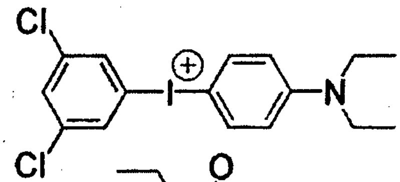

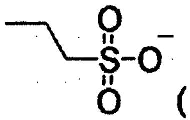

(Io-7)

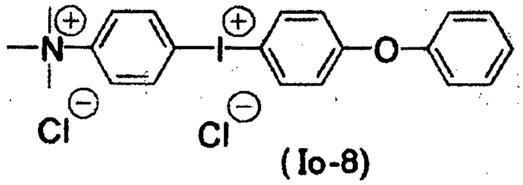

(Io-8)

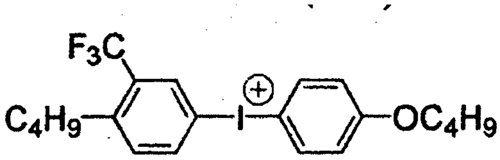

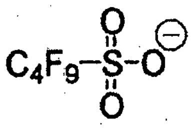

(Io-9)

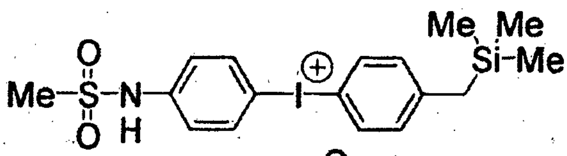

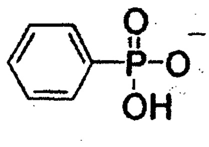

(Io-10)

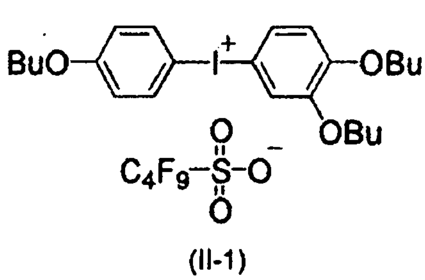

(II-1)

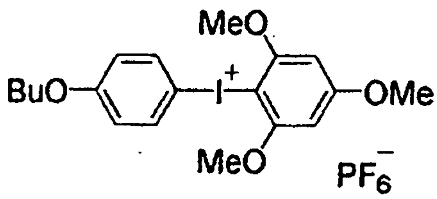

(II-2)

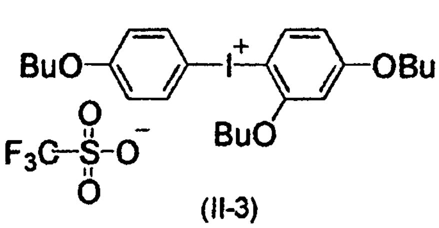

(II-3)

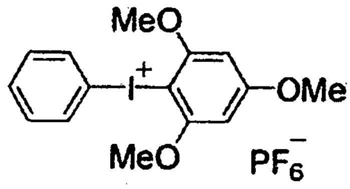

(II-4)

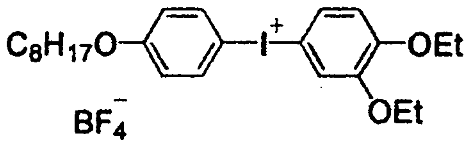

(II-5)

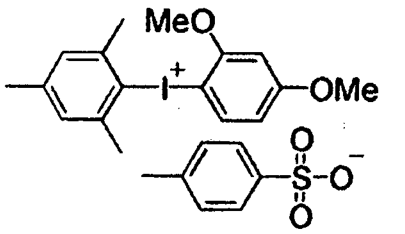

(II-6)

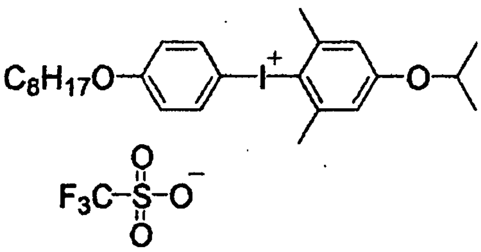

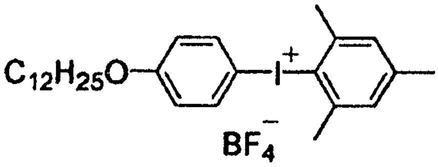

(II-8)

(II-7)

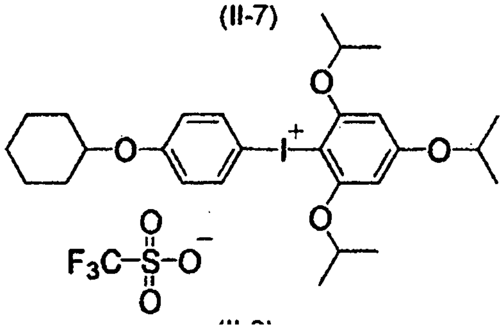

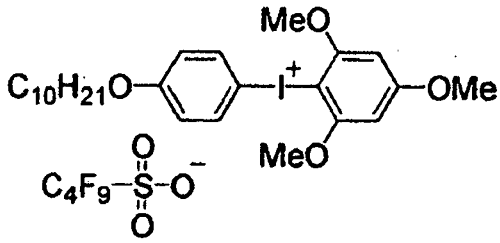

(II-10)

(II-9)

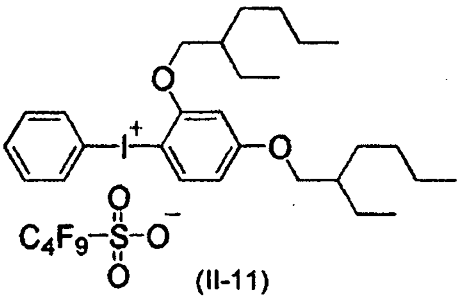

(II-11)

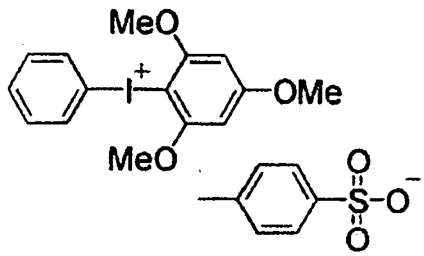

(II-12)

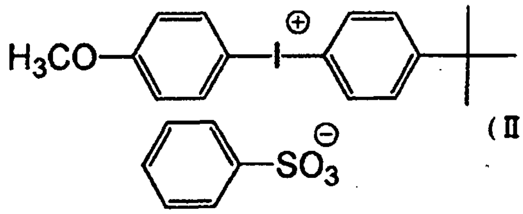

(II-13)

The iodonium salt can be added ordinarily in a ratio from 0.1 to 50% by weight, preferably from 0.5 to 30% by weight, particularly preferably from 1 to 20% by weight, based on the total solid content constituting the image-recording layer. In the range described above, the printing durability is improved.

[Polymerizable compound]

The polymerizable compound which can be used in the invention is an addition-polymerizable compound having at least one ethylenically unsaturated double bond, and it is selected from compounds having at least one, preferably two or more, ethylenically unsaturated double bonds. Such compounds are widely known in the field of art and they can be used in the invention without any particular restriction. The compound has a chemical form, for example, a monomer, a prepolymer, specifically, a dimer, a trimer or an oligomer, or a mixture thereof, or a (co)polymer thereof. Examples of the monomer and copolymer thereof include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Furthermore, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

With respect to specific examples of the monomer, which is an ester of an aliphatic polyhydric alcohol compound with an unsaturated carboxylic acid, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer or isocyanuric acid EO-modified triacrylate is exemplified.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane is exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate is exemplified. As a crotonic acid ester, for example, ethylene glycol dicrotonate, tetramethylene glycol dicrotonate, pentaerythritol dicrotonate and sorbitol tetracrotonate is exemplified. As an isocrotonic acid ester, for example, ethylene glycol diisocrotonate, pentaerythritol diisocrotonate and sorbitol tetraisocrotonate is exemplified. As a maleic acid ester, for example, ethylene glycol dimaleate, triethylene glycol dimaleate, pentaerythritol dimaleate or sorbitol tetramaleate is exemplified.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613. Further, the above-described ester monomers can also be used as a mixture.

Specific examples of the monomer, which is an amide of an aliphatic polyvalent amine compound with an

unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (b) shown below to a polyisocyanate compound having two or more isocyanate groups per molecule, described in JP-B-48-41708.

$$CH_2=C(R_4)COOCH_2CH(R_5)OH \qquad (b)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Furthermore, a photopolymerizable composition having remarkably excellent photosensitive speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers and oligomers described in Journal of Japan Adhesion Society, Vol. 20, No. 7, pages 300 to 308 (1984) can also be used.

Details of the method of using the addition polymerizable compound, for example, selection of the structure, individual or combination use, or addition amount can be appropriately arranged depending on the characteristic design of the final lithographic printing plate precursor. For instance, the compound is selected from the following standpoints.

In view of the sensitivity, a structure having a large content of unsaturated groups per molecule is preferred and in many cases, a difunctional or more functional compound is preferred. In order to increase the strength of image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the addition polymerizable compound are also important factors for the compatibility and dispersibility with other components (for example, a binder polymer, an initiator or a coloring agent) in the image-recording layer. For instance, the compatibility may be improved in some cases by using the compound of low purity or using two or more kinds of the compounds in combination. A specific structure may be selected for the purpose of improving the adhesion property, for example, to a support or an overcoat layer described hereinafter.

The polymerizable compound is preferably used in an amount from 5 to 80% by weight, more preferably from 25 to 75% by weight, based on the nonvolatile component of the image-recording layer. The polymerizable compounds may be used individually or in combination of two or more thereof. In the method of using the addition polymerizable compound, the structure, blend and addition amount can be appropriately selected by taking account of the extent of polymerization inhibition due to oxygen, resolution, fogging property, change in refractive index, surface tackiness and the like. Further, depending on the case, a layer construction, for example, an undercoat layer or an overcoat layer, and a coating method, may also be carried out

[Initiator capable of being used together with initiator represented by formula (I)]

According to the invention, the initiator represented by formula (I) can be used together with other initiator. The other initiator capable of being used together with initiator represented by formula (I) includes compounds which initiate or accelerate polymerization of a radical polymerizable compound. Specifically, a radical polymerization initiator is preferred and, for example, known thermal polymerization initiators, compounds containing a bond having small bond dissociation energy and photopolymerization initiators can be used.

The other initiators capable of being used together in the invention include, for example, (a) organic halides, (b) carbonyl compounds, (c) azo compounds, (d) organic peroxides, (e) metallocene compounds, (f) azide compounds, (g) hexaarylbiimidazole compounds, (h) organic borate compounds, (i) disulfone compounds, (j) oxime ester compounds and (k) onium salt compounds.

As the organic halide (a), compounds described in Paragraph Nos. [0022] to [0023] of JP-A-2008-195018 are

preferred.

As the carbonyl compound (b), compounds described in Paragraph No. [0024] of JP-A-2008-195018 are preferred.

As the azo compound (c), for example, azo compounds described in JP-A-8-108621 can be used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2003-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. 1. Schlesinger, Photogr. Sci. Eng., 18, 387 (1974), T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, U. S. Patent Publication No. 2008/0311520, JP-A-2-150848, JP-A-2-296514 and JP-A-2008-195018, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827 and German Patents 2,904,626, 3,604,580 and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), arsonium salts described in C. S. Wen et al., Teh. Proc. Conf. Rad. Curing ASIA, p. 478, Tokyo, Oct. (1988), and azinium salts described in JP-A-2008-195018 are exemplified.

Of the other initiators described above, the onium salt, in particular, the iodonium salt, the sulfonium salt or the azinium salt is more preferred. Specific examples of these compounds are set forth below, but the invention should not be construed as being limited thereto.

It is also possible to use together an iodonium salt different from the iodonium salt represented by formula (I). Specifically, a diphenyliodonium salt in which $Ar_1$ and $Ar_2$ in formula (I) are the same is exemplified.

Examples of the iodonium salt include diphenyliodonium hexafluorophosphate, bis(4-tert-butylphenyl)iodonium tetraphenylborate and bis(3-tert-trifluoromethylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and
tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1 -(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate,
1-(2-ethylhexyloxy)-4-phenylpyridinium p-toluenesulfonate,
1-(2-ethylhexyloxy)-4-phenylpyridinium perfluorobutanesulfonate,
1-(2-ethylhexyloxy)-4-phenylpyridinium bromide and 1-(2-ethylhexyloxy)4-phenylpyridinium tetrafluoroborate.

The amount of the other initiator capable of being used together is 100% by weight or less with respect to the content of the initiator represented by formula (I). In the range, the printing durability is improved.

[Borate salt]

The image-recording layer according to the invention preferably contains a borate salt. As the borate salt, a tetraarylborate salt is preferred.

Numerous tetraarylborate salts are suitable for the practice of the invention. In general, a tetraarylborate salt comprises a boron center having four bonds to aryl groups. A general representation of the tetraarylborate salt is $[A^+][B(Ar^1)(Ar^2)(Ar^3)(Ar^4)^-]$, wherein $Ar^1$ to $Ar^4$, which may be the same or different, each represents an aryl group and $A^+$ represents a counter cation. The aryl group may be a carbocyclic aromatic group or a heterocyclic aromatic group (for

example, comprising N, O or S in the aromatic ring). The aryl group may be monocyclic or polycyclic, and in some tetraarylborate salts, the boron center can have two or more single bonds to a polycyclic structure (for example, biphenyl).

The aryl group may be unsubstituted or substituted with a suitable substituent at one or more ring positions. Examples of the suitable substituent include an alkyl group, a cycloalkyl group, a carbocyclic or heterocyclic aromatic group, a hydroxy group, a nitro group, a halogen atom, a haloalkyl group, an alkoxy group and a haloalkoxy group.

In one embodiment, the tetraarylborate salt is a tetraphenylborate salt. A tetraphenylborate anion has a general structure $[B(Ph)_4^-]$, wherein Ph each represents a phenyl group which may be unsubstituted or substituted. An example of a suitable tetraphenylborate anion is $[B(C_6H_5)_4{}^-]$ (commonly known as "tetraphenylborate").

In general, the tetraarylborate compound can be introduced into a composition as a salt comprising a suitable counter cation. The property of the counter cation is not restricted. For instance, an alkali ion, for example, $Li^+$, $Na^+$ or $K^+$ is suitable. Also, an ammonium cation which may be unsubstituted, primary, secondary, tertiary or quaternary is suitable. The suitable ammonium cation includes, for example, $NH^+{}_4$, dimethylammonium, diethylammonium, triethylammonium and tributylammonium. A tetraphenylborate salt having an ammonium counter ion is suitable as the tetraarylborate salt in the practice of the invention.

In one embodiment, the tetraarylborate salt includes a quaternary ammonium counter ion. A quaternary ammonium cation has a general structure $[N(R^1)(R^2)(R^3)(R^4)^+]$, wherein $R^1$ to $R^4$, which may be the same or different, each represents an organic substituent. The quaternary ammonium cation has permanently a charge independent of pH of the environment The suitable quaternary ammonium counter ion includes, for example, tetraethylammonium and tetrabutylammonium. As an example, a tetraphenylborate salt having a quaternary ammonium counter ion is suitable as the tetraarylborate salt in the practice of the invention.

A salt comprising a radical-generating onium cation and a tetraarylborate anion may also be suitable in some case, for example, where the radical-generating onium ion is part of the initiator system. In this embodiment, the tetraarylborate is not expected to be the primary radical-generating component. The tetraarylborate is less reactive than a borate having at least one alkyl substituent, and is not commonly useful for generating a radical sufficient to initiate a polymerization reaction at the exposure.

In the case where the tetraarylborate salt is incorporated into the image-recording layer, the image-recording layer contains ordinarily from 0.5 to 20% by weight, more preferably from 1 to 10% by weight, of the tetraarylborate salt. The tetraarylborate anion is ordinarily incorporated by adding to the initiator system described above, but it can be introduced as a counter ion together with a suitable cationic initiator (for example, a radical-generating onium compound) or a cationic dye.

[Other components of image-recording layer]

The image-recording layer according to the invention may contain a binder polymer, a polymer fine particle, a hydrophilic low molecular weight compound, an oil-sensitizing agent and other components in addition to the components described above, if desired.

(1) Binder polymer

In the image-recording layer according to the invention, a binder polymer can be used for the purpose of improving a film strength of the image-recording layer. The binder polymer which can be used in the invention can be selected from those heretofore known without restriction, and polymers having a film-forming property are preferred. Among them, an acrylic resin, a polyvinyl acetal resin and a polyurethane resin are preferred.

As the binder polymer preferable for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group, or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable group and the hydrophilic group makes it possible to maintain good balance between

printing durability and development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferred. In particular, a polyethylene oxide structure containing from 2 to 8 ethylene oxide units is preferred. In order to introduce a hydrophilic group into the binder polymer, a monomer having the hydrophilic group may be copolymerized.

Further, in order to control the ink-receptive property, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate is copolymerized.

Specific examples (1) to (11) of the binder polymer for use in the invention are set forth below, but the invention should not be construed as being limited thereto. A ratio of the repeating units in the binder polymer shown below is indicated by a molar ratio.

(1) 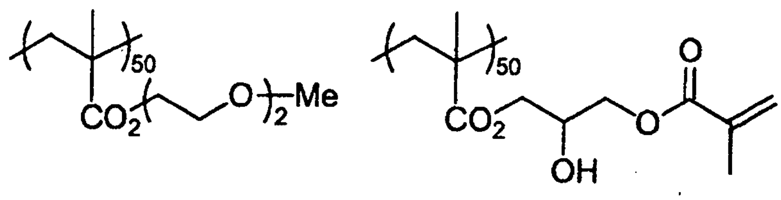

(2) 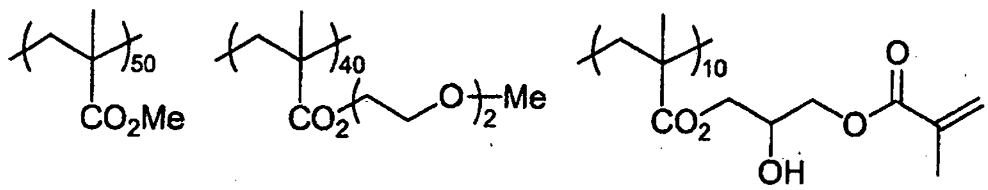

(3) 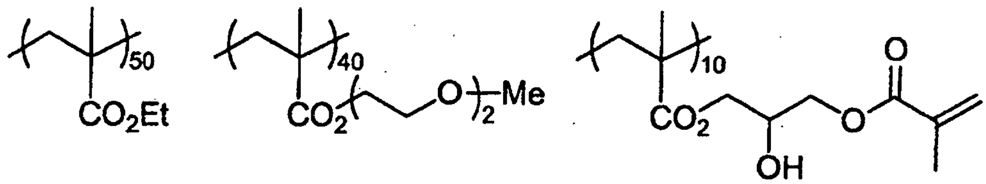

(4) 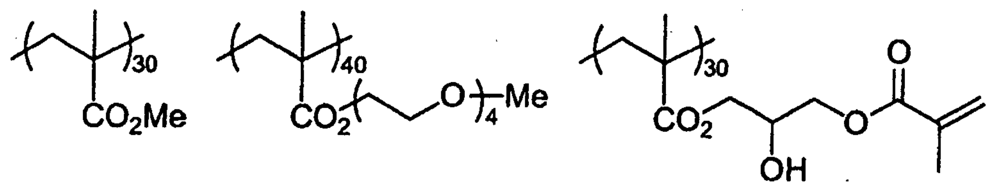

(5) 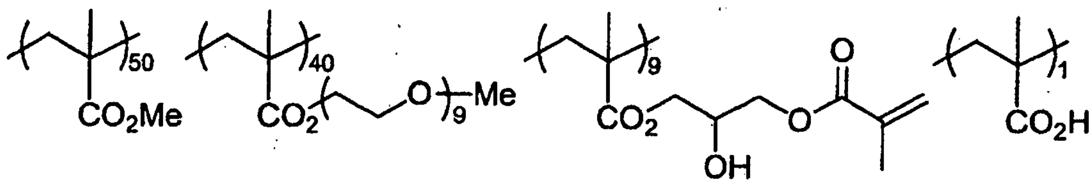

(6)

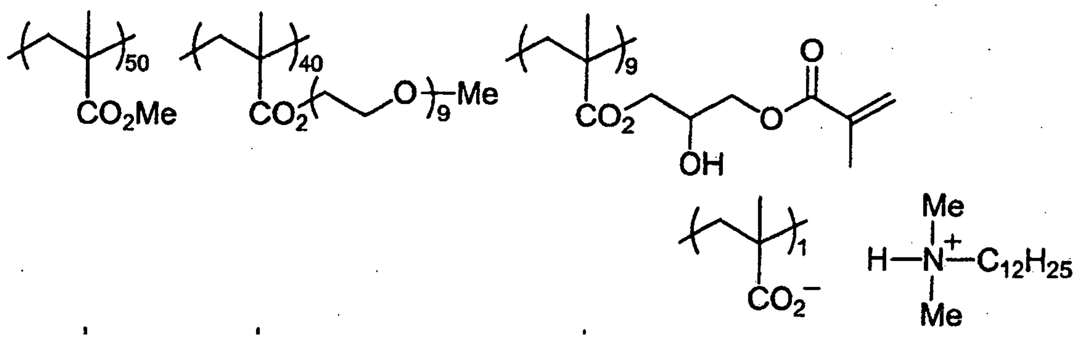

(7)

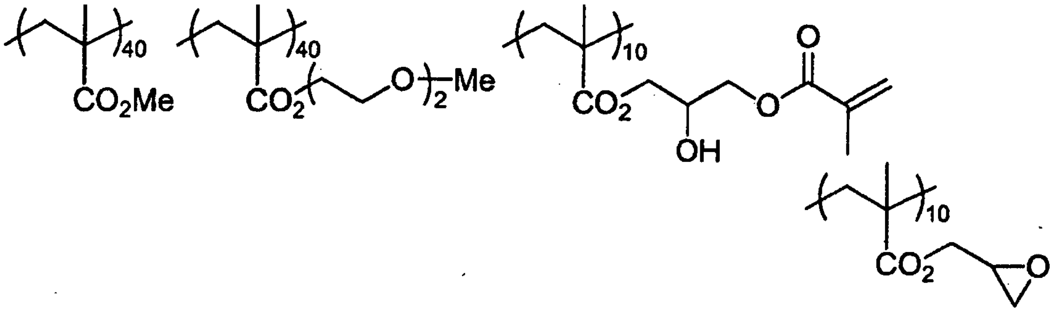

(8)

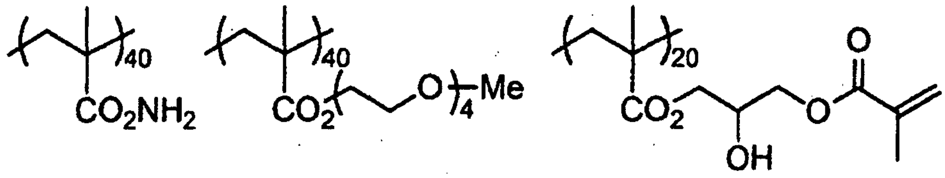

(9)

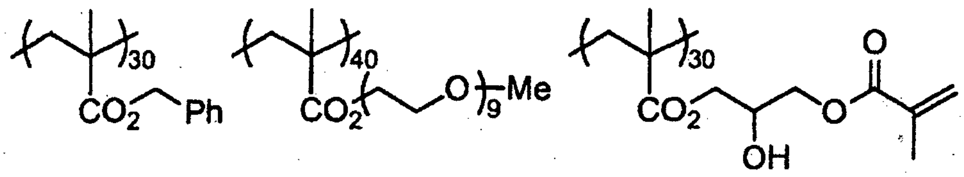

(10)

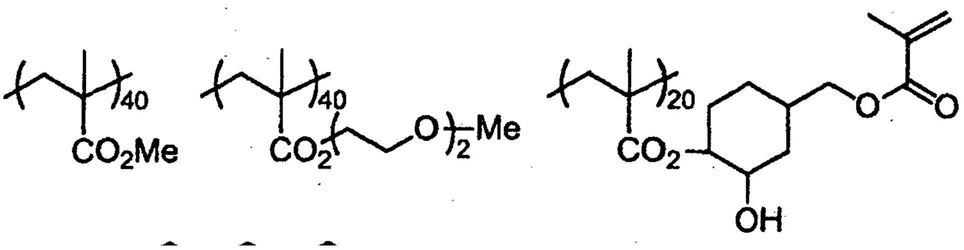

(11) 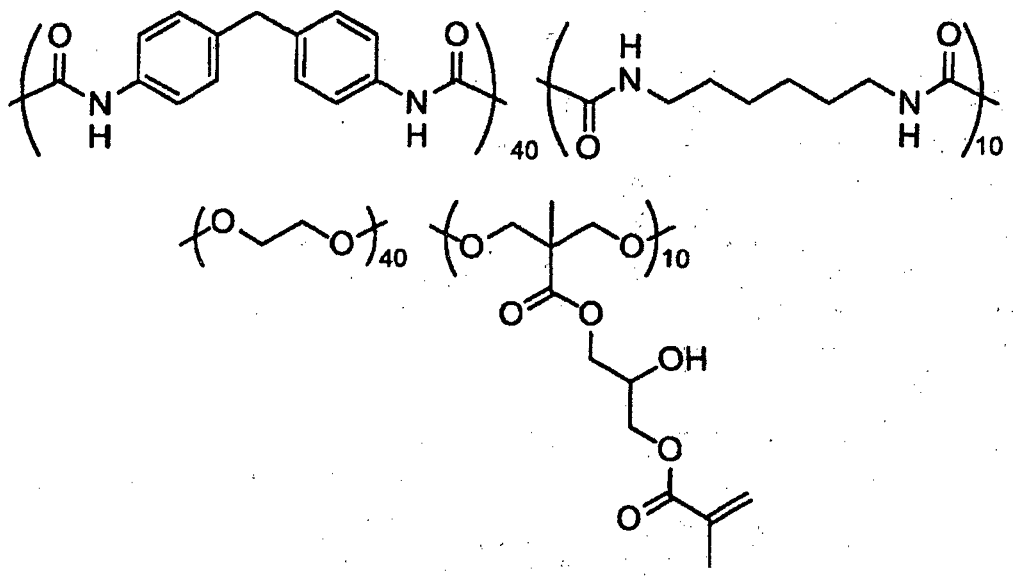

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily from 5 to 90% by weight, preferably from 5 to 80% by weight, more preferably from 10 to 70% by weight, based on the total solid content of the image-recording layer.

(2) Polymer fine particle

In the invention, a polymer fine particle can be used in order to improve the on-press development property. In particular, a polymer fine particle having a polyalkylene oxide structure is preferred. A polymer fine particle having a polyalkylene oxide group in its side chain is particularly preferred. Due to the polymer fine particle, the permeability of dampening water increases to improve the on-press development property.

The polymer fine particle according to the invention is preferably a hydrophobizing precursor capable of converting the image-recording layer to be hydrophobic when heat is applied. The polymer fine particle of hydrophobizing precursor is preferably at least one fine particle selected from hydrophobic thermoplastic polymer fine particle, thermoreactive polymer fine particle, microcapsule having a hydrophobic compound encapsulated therein and microgel (crosslinked polymer fine particle). Among them, polymer fine particle having a polymerizable group and microgel are preferred. In order to increase the on-press development property, it is preferred to have a polyalkylene oxide structure as described above.

As the hydrophobic thermoplastic polymer fine particle, hydrophobic thermoplastic polymer fine particles described, for example, in Research Disclosure No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile and polymethyl methacrylate are more preferred.

The average particle size of the hydrophobic thermoplastic polymer fine particle for use in the invention is preferably from 0.01 to 2.0 μm.

The thermo-reactive polymer fine particle for use in the invention includes polymer fine particle having a thermoreactive group and forms a hydrophobized region by crosslinkage due to thermal reaction and change in the functional group involved therein.

As the thermo-reactive group of the polymer fine particle having a thermo-reactive group for use in the invention, although a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy

group), an isocyanate group performing an addition reaction or a blocked form thereof, an epoxy group, a vinyloxy group and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsules. It is a more preferred embodiment of the image-recording layer containing microcapsules that the hydrophobic constituting components are encapsulated in microcapsules and the hydrophilic components are present outside the microcapsules.

According to the invention, an embodiment containing a crosslinked resin particle, that is, a microgel may be used. The microgel can contain a part of the constituting components of the image-recording layer at least one of in the inside and on the surface thereof. In particular, an embodiment of a reactive microgel containing a radical polymerizable compound (C) on the surface thereof is preferred in view of the image-forming sensitivity and printing durability.

In order to conduct microencapsulation or microgelation of the constituting component of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time lapse stability can be achieved.

The content of the polymer fine particle is preferably in a range from 5 to 90% by weight based on the total solid content of the image-recording layer.

(3) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for instance, a glycol, for example, ethylene glycol, diethylene glycol, triethylene glycol, propylene glycol, dipropylene glycol or tripropylene glycol, or an ether or ester derivative thereof, a polyol, for example, glycerol, pentaerythritol or tris(2-hydroxyethyl) isocyanurate, an organic amine, for example, triethanol amine, diethanol amine or monoethanol amine, or a salt thereof, an organic sulfonic acid, for example, an alkyl sulfonic acid, toluene sulfonic acid or benzene sulfonic acid, or a salt thereof, an organic sulfamic acid, for example, an alkyl sulfamic acid, or a salt thereof, an organic sulfuric acid, for example, an alkyl sulfuric acid or an alkyl ether sulfuric acid, or a salt thereof, an organic phosphonic acid, for example, phenyl phosphonic acid, or a salt thereof, an organic carboxylic acid, for example, tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphthalenedisulfonate or trisodium 1,3,6-naphthalenetrisulfonate; and compounds described in Paragraph Nos. [0026] to [0031] of JP-A-2007-276454 and Paragraph Nos. [0020] to [0047] of JP-A-2009-154525. The salt may also be a potassium salt or a lithium salt

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples thereof include compounds described in Paragraph Nos. [0034] to [0038] of JP-A-2007-276454.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink

receptivity of the image-recording layer and printing durability can be well maintained.

The addition amount of the hydrophilic low molecular weight compound to the image-recording layer is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(4) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an overcoat layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide,1,4-bis(triphenylphosphonio)butane di(hexafluorophosphate), 1,7-bis(triphenylphosphonio)heptane sulfate and 1,9-bis(triphenylphosphonio)nonanenaphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples of the ammonium group-containing polymer include compounds described in Paragraph Nos. [0089] to [0105] of JP-A-2009-208458.

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90, Mw: 45,000)

(2) 2-(Trimethylammonio)ethyl methacrylate hexafluorophosphate /3,6-dioxaheptyl methacrylate copolymer (molar ratio: 20/80, Mw: 60,000)

(3) 2-(Ethyldimethylammonio)ethyl methacrylate p-toluenesulfonate/hexyl methacrylate copolymer (molar ratio: 30/70, Mw: 45,000)

(4) 2-(Trimethylammonio)ethyl methacrylate hexafluorophosphate /2-ethylhexyl methacrylate copolymer (molar ratio: 20/80, Mw: 60,000)

(5) 2-(Trimethylammonio)ethyl methacrylate methylsulfate/hexyl methacrylate copolymer (molar ratio: 40/60, Mw: 70,000)

(6) 2-(Butyldimethylammonio)ethyl methacrylate hexafluorophosphate/3,6-dioxaheptyl methacrylate copolymer (molar ratio: 25/75, Mw: 65,000)

(7) 2-(Butyldimethylammonio)ethyl acrylate hexafluorophosphate/3,6-dioxaheptyl methacrylate copolymer (molar ratio: 20/80, Mw: 65,000)

(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000)

(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

As to the ammonium group-containing polymer, its reduced specific viscosity value (unit: ml/g) determined according to the measuring method described in JP-A-2009-208458 is preferably from 5 to 120, more preferably from 10 to 110, and particularly preferably from 15 to 100. When the reduced specific viscosity value described above is calculated in terms of weight average molecular weight (Mw), from 10,000 to 150,000 is preferred, from 17,000 to 140,000 is more preferred, and from 20,000 to 130,000 is particularly preferred.

The content of the oil-sensitizing agent is preferably from 0.01 to 30.0% by weight, more preferably from 0.1

to 15.0% by weight, still more preferably from 1 to 10% by weight, based on the total solid content of the image-recording layer.

(5) Other components

Other components, for example, a surfactant, a coloring agent, a print-out agent, a polymerization inhibitor, a higher fatty acid derivative, a plasticizer, an inorganic fine particle, an inorganic stratiform compound, a co-sensitizer or a chain transfer agent may further be added to the image-recording layer. Specifically, compounds and addition amounts thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

[Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 $g/m^2$. In the range described above, good sensitivity and good film property of the image-recording layer can be achieved.

[Intermediate layer]

In the lithographic printing plate precursor according to the invention, it is preferred to provide an intermediate layer (also referred to as an undercoat layer) between the image-recording layer and the support. The intermediate layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the intermediate layer acts as a heat insulating layer, decrease in sensitivity due to diffusion of heat generated upon the exposure into the support is prevented.

As a compound for use in the intermediate layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used.

Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for intermediate layer is preferably from 0.1 to 10.0 mmol, most preferably from 0.2 to 5.5 mmol, based on 1 g of the polymer compound.

The weight average molecular weight of the polymer compound for intermediate layer is preferably 5,000 or more, and more preferably from 10,000 to 300,000.

The intermediate layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid,

dihydroxyethylethylenediaminediacetic acid or hydroxyethyliminodiacetic acid) in addition to the compound for the intermediate layer described above in order to prevent the occurrence of stain due to the lapse of time.

The intermediate layer is coated according to a known method. The coating amount (solid content) of the intermediate layer is preferably from 0.1 to 100 mg/$m^2$, and more preferably from 1 to 30 mg/$m^2$.

[Support]

As the support for use in the lithographic printing plate precursor according to the invention, a known support is employed. Of the supports, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 μm.

The support may have a backcoat layer containing an organic polymer compound described in JP-A-5-45885 or an alkoxy compound of silicon described in JP-A-6-35174, provided on the back surface thereof, if desired.

[Overcoat layer]

In the lithographic printing plate precursor according to the invention, an overcoat layer (also referred to as a protective layer) is preferably provided on the image-recording layer, in order to prevent diffusion and penetration of oxygen which inhibits the polymerization reaction at the time of exposure. As a material which can be used in the overcoat layer, any water-soluble polymer and water-insoluble polymer may be appropriately selected to use. The polymers may be used as a mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Of the polymers, a water-soluble polymer relatively excellent in crystallizability is preferably used. Specifically, when polyvinyl alcohol is used as the main component, most preferred results are obtained in the fundamental characteristics, for example, oxygen-blocking property and removability by development

Polyvinyl alcohol for use in the overcoat layer may be partially substituted with ester, ether or acetal as long as it contains unsubstituted vinyl alcohol units for achieving the necessary oxygen-blocking property and water solubility. Also, polyvinyl alcohol may partly have other copolymerization component. Polyvinyl alcohol is obtained by hydrolysis of polyvinyl acetate. As specific examples of the polyvinyl alcohol, those being hydrolyzed in a range from 69.0 to 100% by mole and having a polymerization repeating unit number in a range from 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). Polyvinyl alcohols can be used individually or as a mixture. The content of polyvinyl alcohol in the overcoat layer is preferably from 20 to 95% by weight, and more preferably from 30 to 90% by weight.

Also, a known modified polyvinyl alcohol can be preferably used. Particularly, an acid-modified polyvinyl alcohol having a carboxylic acid group or a sulfonic acid group is preferably used. Specifically, polyvinyl alcohols described in JP-A-2005-250216 and JP-A-2006-259137 are exemplified.

In the case of using other material as a mixture with polyvinyl alcohol, the material mixed with polyvinyl alcohol is preferably a modified polyvinyl alcohol, polyvinyl pyrrolidone or a modified product thereof from the standpoint of the oxygen-blocking property and removability by development. The content thereof is preferably from 3.5 to 80% by weight, more preferably from 10 to 60% by weight, still more preferably from 15 to 30% by weight, in the overcoat layer.

As other component of the overcoat layer, glycerol, dipropylene glycol or the like can be added in an amount corresponding to several % by weight of the (co)polymer to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount of several % by weight of the (co)polymer.

Further, it is also preferred to incorporate an inorganic stratiform compound into the overcoat layer of the lithographic printing plate precursor according to the invention for the purpose of increasing the oxygen-blocking property and property for protecting the surface of image-recording layer. Of the inorganic stratiform compounds, fluorine-based swellable synthetic mica, which is a synthetic inorganic stratiform compound, is particularly useful. Specifically, inorganic stratiform compounds described in JP-A-2005-119273 are preferably exemplified.

Moreover, overcoat layers described in U.S. Patent 3,458,311, JP-B-55-49729, JP-A-2008-15503, JP-A-2008-89916 and Paragraph Nos. [0211] to [0261] of JP-A-2008-139813 are also preferably used for the overcoat layer.

The coating amount of the overcoat layer is preferably in a range from 0.05 to 10 $g/m^2$ in terms of the coating amount after drying. The coating amount is more preferably in a range from 0.1 to 5 $g/m^2$ in the case where the overcoat layer contains the inorganic stratiform compound, and it is more preferably in a range from 0.5 to 5 $g/m^2$ in the case where the overcoat layer does not contain the inorganic stratiform compound.

[b) Image-exposing the negative-working lithographic printing plate precursor with an infrared laser]

The infrared laser for use in the step b) of the plate making method according to the invention is not particularly restricted, and a solid laser or semiconductor laser emitting an infrared ray having a wavelength of 760 to 1,200 nm or the like is preferably exemplified.

With respect to the infrared laser, the output is preferably 100 mW or more, the exposure time per pixel is preferably within 20 microseconds, and the irradiation energy amount is preferably from 10 to 300 $mJ/cm^2$. With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the image exposure.

[c) Exposing the negative-working lithographic printing plate precursor to light for 5 minutes or more under a white lamp which has one light emission peak at 400 to 500 nm and one light emission peak at 500 to 600 nm and does not emit light at 380 nm or less]

As to the white lamp for use in the invention, the term "does not emit light at 380 nm or less" means that the white lamp does not substantially emit light at 380 nm or less. Specifically, it means that a relative emission intensity at 380 nm is less than 0.02 and the relative emission intensity decreases gradually with shortening of a wavelength below 380 nm. The relative emission intensity is a relative value of emission intensity at an optional wavelength when the emission strength of a wavelength at which the emission strength is greatest is taken as 1.

The white lamp for use in the step c) in the plate making method according to the invention is preferably a combination of blue LED using a GaN semiconductor with a phosphor material (phosphor).

Many patents relating to a white LED are filed by Nichia Corp. (Japanese Patent Nos. 2927279, 3503139 and 3700502) and the like. Japanese Patent No. 2927279 relates to a technique of combining an LED chip having a peak of emission wavelength at from 450 to 475 nm with a YAG phosphor material. Japanese Patent No. 3503139 relates to a technique of combining an LED chip having a peak of emission wavelength at from 420 to 490 nm with a garnet phosphor material containing Ce. Japanese Patent No. 3700502 relates to a technique constituting from an LED chip having a quantum well structure and a peak of emission wavelength at from 420 to 490 nm and a garnet phosphor material containing Ce.

The time for the exposure (irradiation) to a white lamp is 5 minutes or more, preferably 10 minutes or more, and most preferably 30 minutes or more. By the exposure to light for the time described above, improvement in the printing durability can be obtained without impairing the on-press development property. When the irradiation time is less than 5 minutes, the effect of improvement in the printing durability cannot be obtained. The upper limit of the irradiation time is 24 hours, preferably within 12 hours, and more preferably within 2 hours. When the irradiation time is too long, degradation of development property in the unexposed area is recognized.

The illuminance on the surface of lithographic printing plate precursor is preferably 300 lux or more. When it is less than 300 lux, the printing durability may not be improved. In view of work, the illuminance of 1,000 or more is preferred.

[d) Removing an unexposed area with at least one of ink and dampening water to produce a lithographic printing plate]

When the lithographic printing plate precursor imagewise exposed and then exposed to light under the white lamp is mounted on a lithographic printing machine and dampening water and printing ink are supplied to the lithographic printing plate precursor to perform printing, in the exposed area of the image-recording layer, the image-recording layer cured by the image exposure and exposure to light by the white lamp forms the printing ink receptive area having the oleophilic surface. ' On the other hand, in the unexposed area, the uncured image-recording layer is removed by dissolution or dispersion with at least one of the dampening water and printing ink supplied to reveal a hydrophilic surface in the area. As a result, the dampening water adheres on the revealed hydrophilic surface and the printing ink adheres to the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on a lithographic printing machine and used as it is for printing a large number of sheets.

## EXAMPLES

The present invention will be described in detail with reference to the following examples, but the invention should not be construed as being limited thereto.

With respect to the polymer used in the example, a ratio of repeating units is indicated as a molar ratio.

### Examples 1 to 16 and Comparative Examples 1 to 11

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/$cm^3$) of pumice having a median size of 25 μm, followed by thorough washing with water. The plate was subjected to etching by immersing in a 25% by weight aqueous sodium hydroxide solution of 45°C for 9 seconds, washed with water, then immersed in a 20% by weight nitric acid at 60°C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current, and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

Then, the plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/$dm^2$ in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/$dm^2$ to form a direct current anodized film of 2.5 g/$m^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/$m^2$. The center line average roughness (Ra) of the support was measured using a stylus having a diameter of 2 μm and found to be 0.51 μm.

(2) Formation of Intermediate layer

Coating solution (1) for intermediate layer shown below was coated on Support (2) described above so as to have a dry coating amount of 20 mg/$m^2$ to prepare a support having an intermediate layer.

<Coating solution (1) for intermediate layer>

| | |
|---|---|
| Polymer compound for intermediate layer having structure shown below | 0.50 g |
| N-(2-Hydroxyethyl)iminodiacetic acid | 0.025 g |
| Water | 500.00 g |

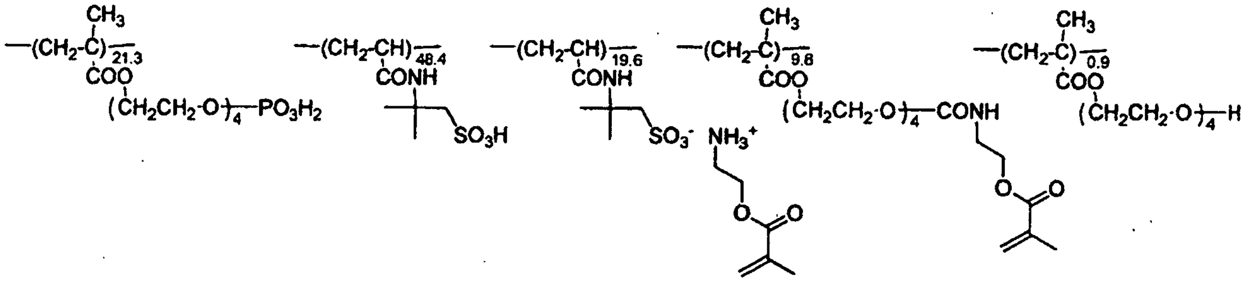

(Mw: 100,000)

(3) Formation of Image-recording layer

Coating solution (1) for image-recording layer having the composition shown below was coated on the intermediate layer formed as described above by a bar and dried in an oven at 100°C for 60 seconds to form an image-recording layer having a dry coating amount of 1.0 g/m$^2$.

Coating solution (1) for image-recording layer was prepared by mixing Photosensitive liquid (1) shown below and Microgel liquid (1) shown below just before the coating, followed by stirring.

<Photosensitive liquid (1)>

| | |
|---|---|
| Binder polymer (1) having structure shown below | 0.240 g |
| Infrared absorbing agent having structure shown below as shown in Tables 1 and 2 | 0.030 g |
| Initiator represented by formula (1) as shown in Tables 1 and 2 | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Borate salt (added only to the examples and comparative examples shown in Table 2) | 0.14 g |
| Oil-sensitizing agent (Phosphonium compound (1) having structure shown below) | 0.055 g |
| Oil-sensitizing agent (Benzyl dimethyl octyl ammonium $PF_6$ salt) | 0.018 g |
| Oil-sensitizing agent (Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

<Microgel liquid (1)>

| | |
|---|---|
| Merogel (1) | 2.640 g |
| Distilled water | 2.425 g |

The structures of Binder polymer (1), Infrared absorbing agent, Phosphonium compound (1), Ammonium group-containing polymer, Hydrophilic low molecular weight compound (1) and Fluorine-based surfactant (1) are shown below.

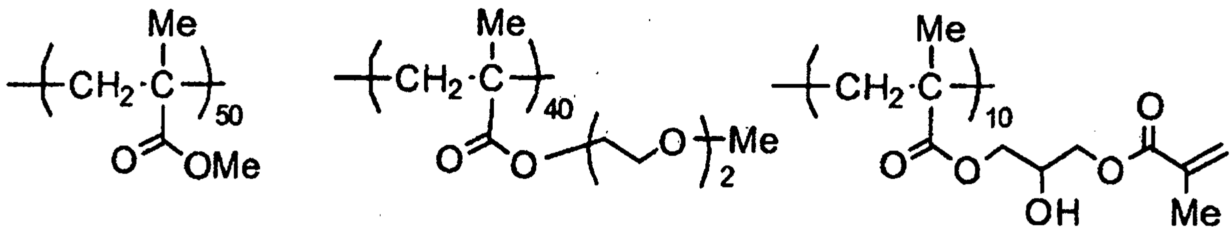

(Mw: 70,000)

Binder polymer (1)

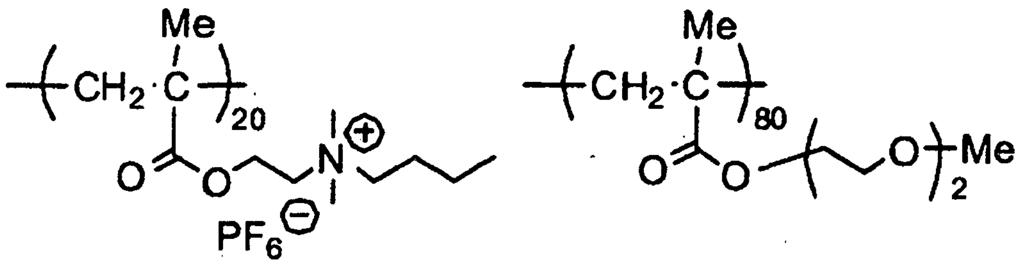

Ammonium group-containing polymer

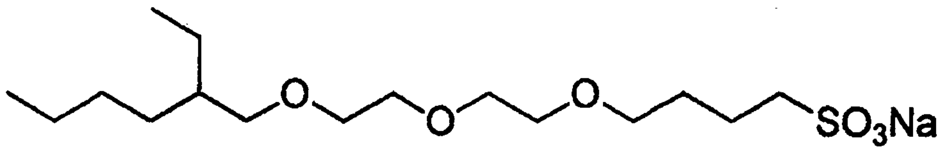

Hydrophilic low molecular weight compound (1)

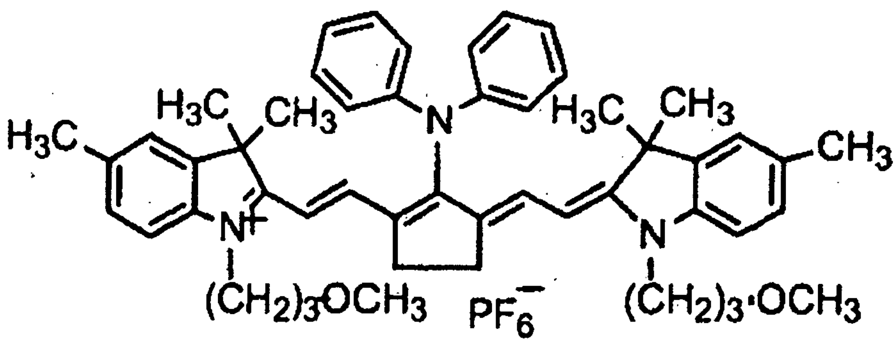

Infrared absorbing agent (1)

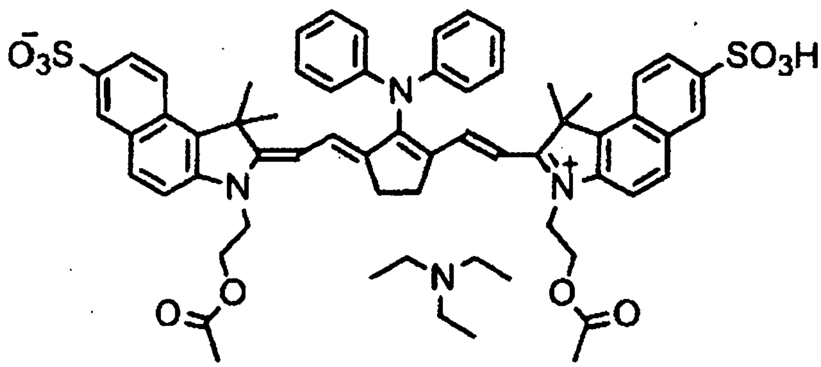

Infrared absorbing agent (2)

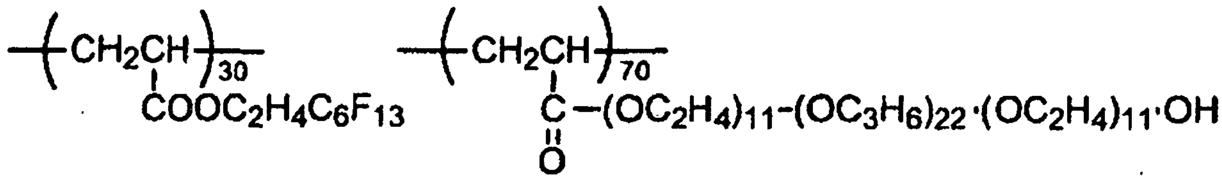

(Mw: 13,000)

Fluorine-based surfactant (1)

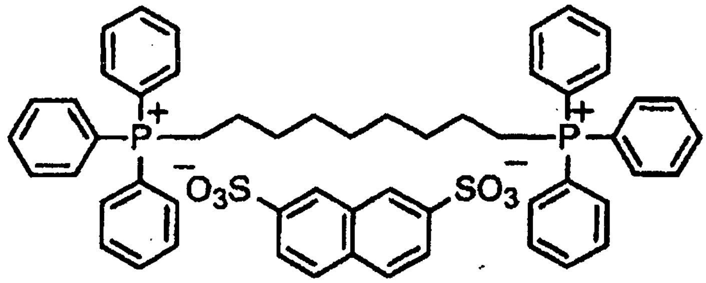

Phosphonium compound (1)

<Preparation of Microgel (1)>

An oil phase component was prepared by dissolving 4.46 g of polyfunctional isocyanate having the structure shown below (produced by Mitsui Chemicals, Inc., 75% by weight ethyl acetate solution), 10 g of an adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals, Inc., 50% by weight ethyl acetate solution), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of polyvinyl alcohol (PVA-205, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 μm.

Polyfunctional isocyanate

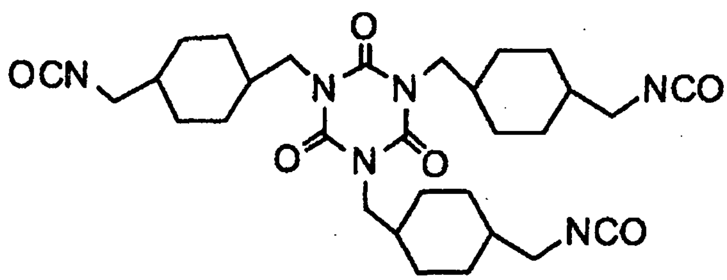

(4) Formation of overcoat layer

Coating solution (1) for overcoat layer having the composition shown below was coated on the image-recording layer described above by a bar and dried in an oven at 120°C for 60 seconds to form a protective layer having a dry coating amount of 0.15 g/$m^2$, thereby preparing the lithographic printing plate precursors for Examples 1 to 16 and Comparative Examples 1 to 11, respectively.

<Coating solution (1) for overcoat layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5% by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

<Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm to prepare Dispersion of inorganic stratiform compound (1). The aspect ratio of the inorganic particle thus-dispersed was 100 or more.

(5) Evaluation of Lithographic printing plate precursor

Each of the lithographic printing plate precursors thus-obtained was exposed by LUXEL PLATESETTER T-6000III equipped with an infrared semiconductor laser, produced by FUJIFILM Corp. under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was exposed to light under a room lamp (white lamp) (illuminance on the surface of lithographic printing plate precursor being 1,500 lux) shown in the tables below for the time shown in the tables below.

The lithographic printing plate precursor exposed to light was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and SPACE COLOR FUSION G (N) ink (produced by DIC Graphics Corp.), the dampening water and ink were supplied according to the standard automatic printing start method of LITHRONE 26 to conduct printing on TOKUBISHI art paper (76.5 kg) at a printing speed of 10,000 sheets per hour.

All operations until the completion of printing including the exposure to light and mounting of plate were carried out under the room lamp (white lamp) described above.

<On-press development property>

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 1 and Table 2.

<Printing durability>

After performing the evaluation for the on-press development property described above, the printing was further continued. As the increase in a number of printing papers, the image-recording layer was gradually abraded to cause decrease in the ink density on the printed material. A number of printing papers wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 1 and Table 2.

TABLE 1

| | Room Lamp | | Initiator | | | | Ultraviolet Absorbing Agent | Borate Salt | Performance Evaluation Result | | |
|---|---|---|---|---|---|---|---|---|---|---|---|
| | Kind | Irradiation Time to Surface of Plate | Kind | $Ar_1$ Hammett Value | $Ar_2$ Hammett Value | Absolute Value of Difference between Hammett Values | Kind | Kind | On-press : Development Property (sheets) | Printing Durability (sheets) | Increase upon Exposure to Light (sheets) |
| Example 1 | White LED Lamp (TOSHIBA LITEC E-CORE LEL-BR9N-F) | 30 min | Io-11 | 0.32 | 0 | 0.32 | (1) | None | 40 | $4.0 \times 10^4$ | $0.7 \times 10^4$ |
| Example 2 | ditto | 30 min | Io-1 | 0.46 | -0.32 | 0.78 | (1) | None | 30 | $4.4 \times 10^4$ | $0.8 \times 10^4$ |
| Example 3 | ditto | 30min | Io-2 | 0.37 | -0.15 | 0.52 | (1) | None | 30 | $4.3 \times 10^4$ | $0.8 \times 10^4$ |
| Example 4 | ditto | 30 min | II-2 | -0.32 | -0.84 | 0.52 | (1) | None | 30 | $4.8 \times 10^4$ | $1.0 \times 10^4$ |
| Example 5 | ditto | 30 min | II-5 | -0.27 | -0.14 | 0.13 | (1) | None | 30 | $4.5 \times 10^4$ | $0.9 \times 10^4$ |
| Example 6 | ditto | 30 min | II-13 | -0.56 | -0.15 | 0.41 | (1) | None | 30 | $4.8 \times 10^4$ | $1.0 \times 10^4$ |
| Example 7 | ditto | 5 min | II-13 | -0.56 | -0.15 | 0.41 | (1) | None | 30 | $4.7 \times 10^4$ | $0.9 \times 10^4$ |
| Example 8 | ditto | 10 min | II-13 | -0.56 | -0.15 | 0.41 | (1) | None | 30 | $4.8 \times 10^4$ | $1.0 \times 10^4$ |
| Example 9 | ditto | 60 min | II-13 | -0.56 | -0.15 | 0.41 | (1) | None | 30 | $4.9 \times 10^4$ | $1.1 \times 10^4$ |
| Example 10 | ditto | 6 hrs | II-13 | -0.56 | -0.15 | 0.41 | (1) | None | 30 | $5.0 \times 10^4$ | $1.2 \times 10^4$ |
| Example 11 | ditto | 12 hrs | II-13 | -0.56 | -0.15 | 0.41 | (1) | None | 30 | $5.0 \times 10^4$ | $1.2 \times 10^4$ |
| Example 12 | ditto | 24 hrs | II-13 | -0.56 | -0.15 | 0.41 | (1) | None | 35 | $5.0 \times 10^4$ | $1.2 \times 10^4$ |
| Example 13 | White LED Lamp (EVER produced by Panasonic) | 30 min | II-13 | -0.56 | -0.15 | 0.41 | (1) | None | 30 | $4.8 \times 10^4$ | $1.0 \times 10^4$ |

(continued)

| | Room Lamp | | Initiator | | | | Ultraviolet Absorbing Agent | Borate Salt | Performance Evaluation Result | | |
|---|---|---|---|---|---|---|---|---|---|---|---|
| | Kind | Irradiation Time to Surface of Plate | Kind | $Ar_1$ Hammett Value | $Ar_2$ Hammett Value | Absolute Value of Difference between Hammett Values | Kind | Kind | On-press : Development Property (sheets) | Printing Durability (sheets) | Increase upon Exposure to Light (sheets) |
| Comparative Example 1 | White Fluorescent Lamp (FL 15W produced by Toshiba Corp.) | 30 min | II-13 | -0.56 | -0.15 | 0.41 | (1) | None | 50 | $4.3 \times 10^4$ | $0.5 \times 10^4$ |
| Comparative Example 2 | None | None | Io-11 | 0.32 | 0 | 0.32 | (1) | None | 40 | $3.3 \times 10^4$ | - |
| Comparative Example 3 | None | None | Io-1 | 0.46 | -0.32 | 0.78 | (1) | None | 30 | $3.6 \times 10^4$ | - |
| Comparative Example 4 | None | None | Io-2 | 0.37 | -0.15 | 0.52 | (1) | None | 30 | $3.5 \times 10^4$ | - |
| Comparative Example 5 | None | None | II-2 | -0.32 | -0.84 | 0.52 | (1) | None | 30 | $3.8 \times 10^4$ | - |
| Comparative Example 6 | None | None | II-5 | -0.27 | -0.14 | 0.13 | (1) | None | 30 | $3.6 \times 10^4$ | - |
| Comparative Example 7 | None | None | II-13 | -0.56 | -0.15 | 0.41 | (1) | None | 30 | $3.8 \times 10^4$ | - |

Note: Characteristics of the room lamps shown in Table 1

TOSHIBA LITEC E-CORE LEL-BR9N-F:

Light emission peak/440 nm, 560 nm (relative emission intensity at 380 nm: 0.01)

Panasonic EVER LED:

Light emission peak/460 nm, 510 nm (relative emission intensity at 380 nm: 0.00)

FL 15W produced by Toshiba Corp.:

Light emission peak/403 nm, 435 nm, 546 nm, 579 nm (relative emission intensity at 380 nm: 0.05)

TABLE 2

| | Room Lamp | | Initiator | | | | Ultraviolet Absorbing Agent | Borate Salt | Performance Evaluation Result | | |
|---|---|---|---|---|---|---|---|---|---|---|---|
| | Kind | Irradiation Time to Surface of Plate | Kind | $Ar_1$ Hammett Value | $Ar_2$ Hammett Value | Absolute Value of Difference between Hammett Values | Kind | Kind | On-press Development Property (sheets) | Printing Durability (sheets) | Increase upon Exposure to Light (sheets) |
| Example 14 | White LED Lamp (TOSHIBA LITEC E-CORE LEL-BR9N-F) | 30min | II-13 | -0.56 | -0.15 | 0.41 | (1) | Sodium tetraphenylborate | 25 | $6.3 \times 10^4$ | $1.3 \times 10^4$ |
| Example 15 | ditto | 30 min | II-13 | -0.56 | -0.15 | 0.41 | (1) | Tetrabutylammonium tetraphenylborate | 25 | $6.3 \times 10^4$ | $1.3 \times 10^4$ |
| Example 16 | ditto | 30 min | II-13 | -0.56 | -0.15 | 0.41 | (2) | Tetrabutylammonium tetraphenylborate | 25 | $6.2 \times 10^4$ | $1.2 \times 10^4$ |
| comparative Example 8 | White Fluorescent Lamp (FL 15W produced by Toshiba Corp.) | 30 min | II-13 | -0.56 | -0.15 | 0.41 | (1) | Sodium tetraphenylborate | 100 or more | $5.8 \times 10^4$ | $0.8 \times 10^4$ |
| Comparative Example 9 | None | None | II-13 | -0.56 | -0.15 | 0.41 | (1) | Sodium tetraphenylborate | 25 | $5.0 \times 10^4$ | - |
| Comparative Example 10 | None | None | II-13 | -0.56 | -0.15 | 0.41 | (1) | Tetrabutylammonium tetraphenylborate | 25 | $5.0 \times 10^4$ | - |
| Comparative Example 11 | None | None | II-13 | -0.56 | -0.15 | 0.41 | (2) | Tetrabutylammonium tetraphenylborate | 25 | $5.0 \times 10^4$ | - |

Examples 21 to 35 and Comparative Examples 21 to 30

(1) Preparation of Support

Support (1) prepared in the same manner as in Example 1 was subjected to a treatment using an aqueous polyacrylic acid solution, in order to ensure the hydrophilicity of the non-image area, to prepare Support (3).

(2) Formation of Image-recording layer

Coating solution (2) for image-recording layer having the composition shown below was coated on Support (3) described above by a bar and dried in an oven at 100°C for 60 seconds to form an image-recording layer having a dry coating amount of 1.0 g/$m^2$, thereby preparing the lithographic printing plate precursors for Examples 21 to 35 and Comparative Examples 21 to 30, respectively.

<Coating solution (2) for image-recording layer>

| | |
|---|---|
| Aqueous dispersion (1) of polymer fine particle shown below | 20.0 g |
| Infrared absorbing agent (2) | 0.2 g |
| Initiator represented by formula (1) as shown in Tables 3 and 4 | 0.5 g |
| Borate salt (added only to the examples and comparative examples shown in Table 4) | 0.45 g |
| Polymerizable compound (SR-399, produced by Sartomer Co.) | 1.50 g |
| Chain transfer agent (Mercapto-3-triazole) | 0.2 g |
| Surfactant (BYK 336, produced by BYK-Chimie GmbH) | 0.4 g |
| Binder polymer (KLUCEL M, produced by Hercules Chemical Co., Inc.) | 4.8 g |
| ELVACITE 4026 (produced by Ineos Acrylica Inc.) | 2.5 g |
| n-Propanol | 55.0 g |
| 2-Butanone | 17.0 g |

The compounds indicated using their trade names in the composition described above are shown below.

SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution)

(Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

(3) Evaluation of Lithographic printing plate precursor

The lithographic printing plate precursors for Examples 21 to 35 and Comparative Examples 21 to 30 prepared

as described above were subjected to the image exposure, exposure to light under a white lamp, on-press development and printing, and the on-press development property and printing durability were evaluated in the same manner as described in Examples 1 to 16 and Comparative Examples 1 to 11. The results obtained are shown in Table 3 and Table 4.

TABLE 3

| | Room Lamp | | Initiator | | | | Ultraviolet Absorbing Agent | Borate Salt | Performance Evaluation Result | | |
|---|---|---|---|---|---|---|---|---|---|---|---|
| | Kind | Irradiation Time to Surface of Plate | Kind | $Ar_1$ Hammett Value | $Ar_2$ Hammett Value | Absolute Value of Difference between Hammett Values | Kind | Kind | On-press Development Property (sheets) | Printing Durability (sheets) | Increase upon Exposure to Light (sheets) |
| Example 21 | White LED Lamp (TOSHIBA LITEC E-CORE LEL-BR9N-F) | 30min | Io-11 | 0.32 | 0 | 0.32 | (2) | None | 30 | $3.8 \times 10^4$ | $0.6 \times 10^4$ |
| Example 22 | ditto | 30min | Io-1 | 0.46 | -0.32 | 0.78 | (2) | None | 25 | $4.1 \times 10^4$ | $0.7 \times 10^4$ |
| Example 23 | ditto | 30 min | Io-2 | 0.37 | -0.15 | 0.52 | (2) | None | 25 | $4.1 \times 10^4$ | $0.7 \times 10^4$ |
| Example 24 | ditto | 30 min | II-2 | -0.32 | -0.84 | 0.52 | (2) | None | 25 | $4.5 \times 10^4$ | $0.9 \times 10^4$ |
| Example 25 | ditto | 30 min | II-5 | -0.27 | -0.14 | 0.13 | (2) | None | 25 | $3.6 \times 10^4$ | $0.8 \times 10^4$ |
| Example 26 | ditto | 30 min | II-13 | -0.56 | -0.15 | 0.41 | (2) | None | 25 | $4.7 \times 10^4$ | $0.9 \times 10^4$ |
| Example 27 | ditto | 5 min | II-13 | -0.56 | -0.15 | 0.41 | (2) | None | 25 | $4.6 \times 10^4$ | $0.8 \times 10^4$ |
| Example 28 | ditto | 10 min | II-13 | -0.56 | -0.15 | 0.41 | (2) | None | 25 | $4.7 \times 10^4$ | $0.9 \times 10^4$ |
| Example 29 | ditto | 60 min | II-13 | -0.56 | -0.15 | 0.41 | (2) | None | 25 | $4.7 \times 10^4$ | $0.9 \times 10^4$ |
| Example 30 | ditto | 6 hrs | II-13 | -0.56 | -0.15 | 0.41 | (2) | None | 25 | $4.8 \times 10^4$ | $1.0 \times 10^4$ |
| Example 31 | ditto | 12 hrs | II-13 | -0.56 | -0.15 | 0.41 | (2) | None | 25 | $4.9 \times 10^4$ | $1.1 \times 10^4$ |
| Example 32 | ditto | 24 hrs | II-13 | -0.56 | -0.15 | 0.41 | (2) | None | 28 | $4.9 \times 10^4$ | $1.1 \times 10^4$ |
| Example 33 | White LED Lamp (EVER produced by | 30 min | II-13 | -0.56 | -0.15 | 0.41 | (2) | None | 25 | $4.7 \times 10^4$ | $0.9 \times 10^4$ |

(continued)

| | | | | | | | | | | | |
|---|---|---|---|---|---|---|---|---|---|---|---|
| | Panasonic) | | | | | | | | | | |
| Comparative Example 21 | White Fluorescent Lamp (FL 15W produced by Toshiba Corp.) | 30min | II-13 | -0.56 | -0.15 | 0.41 | (2) | None | 40 | $4.3 \times 10^4$ | $0.5 \times 10^4$ |
| Comparative Example 22 | None | None | Io-11 | 0.32 | 0 | 0.32 | (2) | None | 30 | $3.2 \times 10^4$ | -- |
| Comparative Example 23 | None | None | Io-1 | 0.46 | -0.32 | 0.78 | (2) | None | 25 | $3.4 \times 10^4$ | -- |
| Comparative Example 24 | None | None | Io-2 | 0.37 | -0.15 | 0.52 | (2) | None | 25 | $3.4 \times 10^4$ | -- |
| Comparative Example 25 | None | None | II-2 | -0.32 | -0.84 | 0.52 | (2) | None | 25 | $3.6 \times 10^4$ | -- |
| Comparative Example 26 | None | None | II-5 | -0.27 | -0.14 | 0.13 | (2) | None | 25 | $2.8 \times 10^4$ | -- |
| Comparative Example 27 | None | None | II-13 | 0.56 | -0.15 | 0.41 | (2) | None | 25 | $3.8 \times 10^4$ | -- |

TABLE 4

| | Room Lamp | | Initiator | | | | Ultraviolet Absorbing Agent | Borate Salt | Performance Evaluation Result | | |
|---|---|---|---|---|---|---|---|---|---|---|---|
| | Kind | irradiation Time to Surface of Plate | Kind | $Ar_1$ Hammett Value | $Ar_2$ Hammett Value | Absolute Value of Difference between Hammett Values | Kind | Kind | On-press Development Property (sheets) | Printing Durability (sheets) | Increase upon Exposure to Light (sheets) |
| Example 34 | White LED Lamp (TOSHIBA LITEC E-CORE LEL-BR9N-F) | 30 min | II-13 | -0.56 | -0.15 | 0.41 | (2) | Sodium tetraphenylborate | 20 | $5.6 \times 10^4$ | $1.1 \times 10^4$ |
| Example 35 | ditto | 30min | II-13 | -0.56 | -0.15 | 0.41 | (2) | Tetrabutylammonium tetraphenylborate | 20 | $5.6 \times 10^4$ | $1.1 \times 10^4$ |
| Comparative Example 28 | White Fluorescent Lamp (FL 15W produced by Toshiba Corp.) | 30min | II-13 | -0.56 | -0.15 | 0.41 | (2) | Sodium tetraphenylborate | 100 or more | $5.1 \times 10^4$ | $0.6 \times 10^4$ |
| Comparative Example 29 | None | None | II-13 | -0.56 | -0.15 | 0.41 | (2) | Sodium tetraphenylborate | 20 | $4.5 \times 10^4$ | - |
| Comparative Example 30 | None | None | II-13 | -0.56 | -0.15 | 0.41 | (2) | Tetrabutylammonium tetraphenylborate | 20 | $4.5 \times 10^4$ | - |

INDUSTRIAL APPLICABILITY

According to the invention, a plate making method of a lithographic printing plate which is good in both on-press development property of a lithographic printing plate precursor and printing durability of a lithographic printing plate obtained from the lithographic printing plate precursor can be provided.

## Claims

**1.** A plate making method of a lithographic printing plate, comprising performing the following steps a) to d) in this order:

a) supplying a negative-working lithographic printing plate precursor having on a support an image-recording layer containing an infrared absorbing agent, an initiator represented by formula (I) and a polymerizable compound, wherein the image-recording layer is capable of being removed with at least one of ink and dampening water,
b) image-exposing the negative-working lithographic printing plate precursor with an infrared laser,
c) exposing the negative-working lithographic printing plate precursor to light for 5 minutes or more under a white lamp which has one light emission peak at 400 to 500 nm and one light emission peak at 500 to 600 nm and does not emit light at 380 nm or less,
d) removing an unexposed area with at least one of ink and dampening water to produce a lithographic printing plate:

$$Ar_1\text{-}I^+\text{-}Ar_2Z^- \qquad \text{Formula (I)}$$

in formula (I), $Ar_1$ and $Ar_2$ each represents a benzene ring which may have a substituent and $Ar_1$ and $Ar_2$ represents structures different from each other, and $Z^-$ represents a counter anion.

**2.** The plate making method of a lithographic printing plate as claimed in Claim 1, wherein a sum of Hammett σ values of the substituents on the benzene ring represented by $Ar_2$ in the formula (I) is a negative value.

**3.** The plate making method of a lithographic printing plate as claimed in Claim 2, wherein a sum of Hammett σ values of the substituents on the benzene ring represented by $Ar_1$ in the formula (I) is 0 or a negative value.

**4.** The plate making method of a lithographic printing plate as claimed in Claim 3, wherein an absolute value of a difference between the sum of Hammett σ values of the substituents on the benzene ring represented by $Ar_1$ and the sum of Hammett σ values of the substituents on the benzene ring represented by $Ar_2$ in the formula (I) is 0.3 or more.

**5.** The plate making method of a lithographic printing plate as claimed in any one of Claims 1 to 4, wherein the image-recording layer contains a borate salt

**6.** The plate making method of a lithographic printing plate as claimed in any one of Claims 1 to 5, wherein a time for the exposure to light under a white lamp in the step d) is 10 minutes or more.

**7.** The plate making method of a lithographic printing plate as claimed in Claim 6, wherein the time for the exposure to light under a white lamp is 30 minutes or more.

## Patentansprüche

**1.** Plattenherstellungsverfahren für eine Lithographiedruckplatte, umfassend das Durchführen der folgenden Schritte a) bis d) in dieser Reihenfolge:

a) Zuführen eines negativ-arbeitenden Lithographiedruckplattenvorläufers, der auf einem Träger eine Bildaufzeichnungsschicht aufweist, die einen Infrarotabsorber, einen durch die Formel (I) dargestellten Initiator und eine polymerisierbare Verbindung umfasst, worin die Bildaufzeichnungsschicht in der Lage ist, mit zumindest einem von Tinte und Anfeuchtwasser entfernt zu werden,

b) bildweises Belichten des negativ-arbeitenden Lithographiedruckplattenvorläufers mit einem Infrarotlaser,
c) Belichten des negativ-arbeitenden Lithographiedruckplattenvorläufers für 5 Minuten oder länger unter einer Weißlichtlampe, die einen Lichtemissionspeak bei 400 bis 500 nm und einen Lichtemissionspeak bei 500 bis 600 nm aufweist, und welche kein Licht bei 380 nm oder kürzer emittiert,
d) Entfernen eines nicht-belichteten Bereichs mit zumindest einem von Tinte und Anfeuchtwasser, um eine Lithographiedruckplatte herzustellen:

$$Ar_1\text{-}I^+\text{-}Ar_2Z^- \qquad \text{Formel (I)}$$

worin in Formel (I) $Ar_1$ und $Ar_2$ jeweils einen Benzolring darstellen, der einen Substituenten aufweisen kann, und $Ar_1$ und $Ar_2$ voneinander verschiedene Struktur darstellen, und $Z^-$ ein Gegen-Anion darstellt.

**2.** Plattenherstellungsverfahren für eine Lithographiedruckplatte gemäß Anspruch 1, worin die Summe der Hammett-σ-Werte der Substituenten an dem Benzolring, der in der Formel (I) durch $Ar_2$ dargestellt wird, ein negativer Wert ist.

**3.** Plattenherstellungsverfahren für eine Lithographiedruckplatte gemäß Anspruch 2, worin die Summe der Hammett-σ-Werte der Substituenten an dem Benzolring, der in der Formel (I) durch $Ar_1$ dargestellt wird, 0 oder ein negativer Wert ist.

**4.** Plattenherstellungsverfahren für eine Lithographiedruckplatte gemäß Anspruch 3, worin in der Formel (I) der Absolutwert des Unterschieds zwischen der Summe der Hammett-σ-Werte der Substituenten an dem Benzolring, der durch $Ar_1$ dargestellt wird, und der Summe der Hammett-σ-Werte der Substituenten an dem Benzolring, der durch $Ar_2$ dargestellt wird, 0,3 oder mehr beträgt.

**5.** Plattenherstellungsverfahren für eine Lithographiedruckplatte gemäß irgendeinem der Ansprüche 1 bis 4, worin die Bildaufzeichnungsschicht ein Boratsalz umfasst.

**6.** Plattenherstellungsverfahren für eine Lithographiedruckplatte gemäß irgendeinem der Ansprüche 1 bis 5, worin die Belichtungszeit unter einer Weißlichtlampe im Schritt d) 10 Minuten oder mehr beträgt.

**7.** Plattenherstellungsverfahren für eine Lithographiedruckplatte gemäß Anspruch 6, worin die Belichtungszeit unter einer Weißlichtlampe 30 Minuten oder mehr beträgt.

## Revendications

**1.** Procédé de fabrication d’une plaque d’impression lithographique, consistant à réaliser les étapes a) à d) suivantes dans cet ordre :

a) fournir un précurseur de plaque d’impression lithographique négative ayant sur un support une couche d’impression d’image contenant un agent absorbant les infrarouges, un initiateur représenté par la formule (I) et un composé polymérisable, dans lequel la couche d’impression d’image peut être retirée avec au moins l’une ou l’autre d’encre et d’eau de mouillage,
b) exposer selon une image le précurseur de plaque d’impression lithographique négative à un laser infrarouge,
c) exposer le précurseur de plaque d’impression lithographique négative à de la lumière pendant 5 minutes ou plus sous une lampe blanche qui présente un pic d’émission lumineuse de 400 à 500 nm et un pic d’émission lumineuse de 500 à 600 nm et n’émet pas de lumière à 380 nm ou moins,
d) retirer une zone non exposée avec au moins l’une ou l’autre d’encre et d’eau de mouillage pour produire une plaque d’impression lithographique :

$$Ar_1\text{-}I^+\text{-}Ar_2Z^- \qquad \text{Formule (I)}$$

dans la formule (I), $Ar_1$ et $Ar_2$ représentent chacun un cycle benzène qui peut comprendre un substituant et $Ar_1$ et $Ar_2$ représentent des structures différentes l’une de l’autre et $Z^-$ représente un contre-anion.

2. Procédé de fabrication d'une plaque d'impression lithographique selon la revendication 1, dans lequel une somme des valeurs de Hammett σ des substituants sur le cycle benzène représenté par $Ar_2$ dans la formule (I) est une valeur négative.

3. Procédé de fabrication d'une plaque d'impression lithographique selon la revendication 2, dans lequel une somme des valeurs de Hammett σ des substituants du cycle benzène représenté par $Ar_1$ dans la formule (I) est 0 ou une valeur négative.

4. Procédé de fabrication d'une plaque d'impression lithographique selon la revendication 3, dans lequel une valeur absolue d'une différence entre la somme de valeurs de Hammett σ des substituants sur le cycle benzène représenté par $AR_1$ et la somme des valeurs de Hammett σ des substituants sur le cycle benzène représenté par $AR_2$ dans la formule (I) est de 0,3 ou plus.

5. Procédé de fabrication d'une plaque d'impression lithographique selon l'une quelconque des revendications 1 à 4, dans lequel la couche d'impression d'image contient un sel de borate.

6. Procédé de fabrication d'une plaque d'impression lithographique selon l'une quelconque des revendications 1 à 5, dans lequel une durée d'exposition à la lumière sous une lampe blanche à l'étape d) est de 10 minutes ou plus.

7. Procédé de fabrication d'une plaque d'impression lithographique selon la revendication 6, dans lequel la durée d'exposition à la lumière sous une lampe blanche est de 30 minutes ou plus.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2938397 B
- JP 2001277740 A
- JP 2001277742 A
- JP 2002287334 A
- JP 2006188038 A
- JP 2005119273 A
- US 20090025591 A
- JP 2005196030 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001133969 A
- JP 2002278057 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2008195018 A
- JP 8108621 A
- JP 61166544 A
- JP 2003328465 A
- US 4069055 A
- JP 4365049 A
- US 4069056 A
- EP 104143 A
- US 339049 A
- EP 410201 A
- US 20080311520 A
- JP 2150848 A
- JP 2296514 A
- EP 370693 A
- EP 390214 A
- EP 233567 A
- EP 297443 A
- EP 297442 A
- US 4933377 A
- US 161811 A
- US 410201 A
- US 4760013 A
- US 4734444 A
- US 2833827 A
- DE 2904626
- DE 3604580
- DE 3604581
- JP 9123387 A
- JP 9131850 A
- JP 9171249 A
- JP 9171250 A

- EP 931647 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- JP 2005250216 A
- JP 2006259137 A
- US 3458311 A
- JP 55049729 B
- JP 2008015503 A
- JP 2008089916 A
- JP 2008139813 A
- JP 2927279 B
- JP 3503139 B
- JP 3700502 B


**Non-patent literature cited in the description**


- **SENRYO BINRAN.** *The Society of Synthetic Organic Chemistry, Japan,* 1970
- Saishin Ganryo Binran. *Pigment Technology Society of Japan,* 1977
- Saishin Ganryo Ovo Gijutsu. CMC Publishing Co., Ltd, 1986
- Insatsu Ink Gijutsu. CMC Publishing Co., Ltd, 1984
- Kinzoku Sekken no Seishitsu to Oyo. **SAIWAI SHOBO.** Insatsu Ink Gijutsu. CMC Publishing Co., Ltd, 1984
- Saishin Ganryo Oyo Gijutsu). CMC Publishing Co., Ltd, 1986
- Saishin Ganrvo Oyo Gijutsu. CMC Publishing Co., Ltd, 1986
- **NAOKI INAMOTO.** Kagaku Seminar 10, Hammett Soku-Kozo to Hannosei-. Maruzen Co., Ltd, June 1983
- *Journal of Japan Adhesion Society,* 1984, vol. 20 (7), 300-308
- **S. 1. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh. Proc. Conf. Rad. Curing ASIA,* 1988, 478
- *Research Disclosure,* 1992